# EUROPEAN PATENT APPLICATION

(11) **EP 4 391 074 A1**
(43) Date of publication of application: **26.06.2024**
(21) Application number: 23211502.2
(22) Date of filing: 22.11.2023
(51) Int. Cl.: H01L 29/423, H01L 29/49, H10B 12/00

(54) **INTEGRATED CIRCUIT DEVICES AND METHODS OF FORMING THE SAME**

(30) Priority: 19.12.2022 KR 20220178693
(71) Applicant: Samsung Electronics Co., Ltd., Suwon-si, Gyeonggi-do 16677 (KR)
(72) Inventor: LEE, Hyunjung, 16677 Suwon-si (KR); KONG, Dongsik, 16677 Suwon-si (KR); KIM, Junsoo, 16677 Suwon-si (KR); LEE, Junbum, 16677 Suwon-si (KR); LEE, Jinseong, 16677 Suwon-si (KR)
(74) Representative: Marks & Clerk LLP

(57) **Abstract**

Integrated circuit devices (100) may include a substrate (102) including a word line trench (WT) extending longitudinally in a first horizontal direction (X), a gate dielectric film (120) extending along an inner surface of the word line trench, a word line (WL) in a lower portion of the word line trench on the gate dielectric film and extending longitudinally in the first horizontal direction, and an insulating capping pattern (128) in an upper portion of the word line trench on the word line and extending longitudinally in the first horizontal direction. The word line may include a work-function control conductive plug (122B) including a conductive metal nitride that include a metal dopant, and the work-function control conductive plug includes a top surface in contact with a bottom surface of the insulating capping pattern, a sidewall in contact with the gate dielectric film, and a bottom surface in contact with a monolithic layer (122A).

## Description

### BACKGROUND

The inventive concept relates to an integrated circuit (IC) device, and more particularly, to an IC device including a buried word line.

As the integration density of IC devices including a plurality of word lines of a buried channel array transistor (BCAT) formed in a substrate increases, a pitch between the plurality of word lines has decreased, and a gate induced drain leakage (GIDL) current has increased. Thus, refresh characteristics of the IC devices may be adversely affected. Accordingly, to reduce/inhibit the occurrence of a GIDL current and precisely control a threshold voltage of a gate electrode, a gate electrode including heterogeneous materials having different work functions has been developed.

### SUMMARY

The inventive concept provides an integrated circuit (IC) device, which may reduce or inhibit the occurrence of a leakage current while reducing a resistance of a word line, and have improved electrical characteristics, such as refresh characteristics.

According to an aspect of the inventive concept, there is provided an IC device comprising a substrate; a word line that is in the substrate and extends longitudinally in a first horizontal direction; a gate dielectric film extending between the substrate and the word line; and an insulating capping pattern that is in the substrate and on the word line, the insulating capping pattern extending longitudinally in the first horizontal direction, wherein the word line comprises a work-function control conductive plug that comprises a conductive metal nitride comprising a metal dopant, and the work-function control conductive plug comprises a top surface in contact with a bottom surface of the insulating capping pattern, a sidewall in contact with the gate dielectric film and a bottom surface in contact with a monolithic layer.

According to an aspect of the inventive concept, there is provided an IC device including a substrate including a word line trench, the word line trench extending longitudinally in a first lateral direction, a gate dielectric film extending along (e.g., covering) an inner surface of the word line trench, a word line in (e.g., filling) a lower portion of the word line trench on the gate dielectric film, the word line extending longitudinally in the first lateral direction, and an insulating capping pattern in (e.g., filling) an upper portion of the word line trench on the word line, the insulating capping pattern extending longitudinally in the first lateral direction, wherein the word line includes a work-function control conductive plug including a conductive metal nitride including a metal dopant, and the work-function control conductive plug includes a top surface in contact with a bottom surface of the insulating capping pattern, a sidewall in contact with the gate dielectric film, and a bottom surface in contact with a single layer (e.g., a monolithic layer). In some embodiments, the conductive metal nitride may be formed by doping the conductive metal nitride with the metal dopant.

According to other aspect of the inventive concept, there is provided an IC device including a substrate including a plurality of active regions and a word line trench, the plurality of active regions being defined by a device isolation film, and the word line trench extending longitudinally in a first lateral direction across the plurality of active regions, a gate dielectric film in contact with the plurality of active regions and the device isolation film inside the word line trench, a word line in (e.g., filling) a lower portion of the word line trench on the gate dielectric film, the word line extending longitudinally in the first lateral (horizontal) direction, an insulating capping pattern in (e.g., filling) an upper portion of the word line trench on the word line, the insulating capping pattern extending longitudinally in the first lateral direction; and a pair of source/drain regions on respective sides of the word line in one of the plurality of active regions, wherein the word line includes a work-function control conductive plug including a conductive metal nitride that includes a metal dopant, the work-function control conductive plug including a gate top surface in contact with the insulating capping pattern and a pair of upper sidewalls in contact with the gate dielectric film, the pair of upper sidewalls facing the pair of source/drain regions, respectively, and the work-function control conductive plug filling the word line trench in a second lateral (horizontal) direction without being cut off (e.g. extending continuously) between the pair of upper sidewalls, wherein the second lateral direction is perpendicular to the first lateral direction, and a first conductive plug including an undoped conductive metal nitride, the first conductive plug including a first top surface in contact with a bottom surface of the work-function control conductive plug and a pair of first sidewalls in contact with the gate dielectric film, and the first conductive plug filling the word line trench in the second lateral direction without being cut off (e.g. extending continuously) between the pair of first sidewalls. In some embodiments, the conductive metal nitride may be formed by doping the conductive metal nitride with the metal dopant. In some embodiments, the work-function control conductive plug extends continuously in the second horizontal lateral direction between the pair of upper sidewalls, and the first conductive plug extends continuously in the second lateral direction between the pair of first sidewalls.

According to other aspect of the inventive concept, there is provided an IC device including a substrate including a word line trench, the word line trench extending longitudinally in a first lateral direction, a gate dielectric film extending along (e.g., covering) an inner surface of the word line trench, a word line in (e.g., filling) a lower portion of the word line trench on the gate dielectric film, the word line extending longitudinally in the first lateral direction, and an insulating capping pattern in (e.g., filling) an upper portion of the word line trench on the word line, the insulating capping pattern extending longitudinally in the first lateral direction, wherein the word line includes a titanium nitride (TiN) plug that includes a lanthanum (La) as a dopant and includes a gate top surface in contact with the insulating capping pattern and a pair of upper sidewalls in contact with the gate dielectric film, the TiN plug filling the word line trench in a second lateral direction without being cut off between the pair of upper sidewalls, wherein the second lateral direction is perpendicular to the first lateral direction, and an undoped TiN plug having a first top surface in contact with a bottom surface of the TiN plug and a pair of first sidewalls in contact with the gate dielectric film, the undoped TiN plug filling the word line trench in the second lateral direction without being cut off between the pair of first sidewalls, wherein, one of the pair of upper sidewalls and one of the pair of first sidewalls are on the same plane extend along one planar surface without a step adjacent to an interface between the TiN plug and the undoped TiN plug. In some embodiments, the TiN plug is formed by doping the TiN plug with the La dopant. In some embodiments, TiN plug extending continuously in the second lateral horizontal direction between the pair of upper sidewalls, and the undoped TiN plug extending continuously in the second lateral horizontal direction between the pair of first sidewalls. In some embodiments, the one of the pair of upper sidewalls and the one of the pair of first sidewalls may be on the same plane without a step adjacent to the interface between the La-doped TiN plug and the undoped TiN plug.

At least some of the above and other features of the invention are set out in the claims.

### BRIEF DESCRIPTION OF THE DRAWINGS

Example embodiments of the present inventive concept will be more clearly understood from the following detailed description taken in conjunction with the accompanying drawings in which:
FIG. 1 is a layout diagram of a memory cell array region of an integrated circuit (IC) device according to some embodiments of the present inventive concept;
FIGS. 2A to 2D are cross-sectional views of an IC device according to some embodiments of the present inventive concept. FIG. 2A is a cross-sectional view taken along a line X1- X1' of FIG. 1, FIG. 2B is a cross-sectional view taken along a line X2 - X2' of FIG. 1, FIG. 2C is a cross-sectional view taken along a line Y1 - Y1' of FIG. 1, and FIG. 2D is an enlarged cross-sectional view of a portion "EX1" of FIG. 2C;
FIG. 3 is a cross-sectional view of an IC device according to some embodiments of the present inventive concept;
FIG. 4 is a cross-sectional view of an IC device according to some embodiments of the present inventive concept;
FIG. 5 is a cross-sectional view of an IC device according to some embodiments of the present inventive concept;
FIG. 6A is a layout diagram of an IC device according to some embodiments of the present inventive concept;
FIG. 6B is a cross-sectional view taken along lines X1 - X1' and Y1 - Y1' of FIG. 6A according to some embodiments of the present inventive concept;
FIG. 7A is a layout diagram of an IC device according to some embodiments of the present inventive concept;
FIG. 7B is a perspective view of the IC device shown in FIG. 7A according to some embodiments of the present inventive concept;
FIGS. 8A through 16B are cross-sectional views illustrating a method of manufacturing an IC device according to some embodiments of the present inventive concept. FIGS. 8A, 9A, 10A, 11A, 12A, 13A, 14A, 15A and 16A are cross-sectional views taken along line X1 - X1' of FIG. 1, and FIGS. 8B, 9B, 10B, 11B, 12B, 13B, 14B, 15B and 16B are cross-sectional views taken along line Y1 - Y1' of FIG. 1,;
FIGS. 17A and 17B are cross-sectional views illustrating a method of manufacturing an IC device according to some embodiments of the present inventive concept; and
FIGS. 18A and 18B are cross-sectional views illustrating a method of manufacturing an IC device according to some embodiments of the present inventive concept.

### DETAILED DESCRIPTION

Hereinafter, example embodiments of the present inventive concept will be described in detail with reference to the accompanying drawings. The same reference numerals are used to denote the same elements in the drawings, and repeated descriptions thereof are omitted.

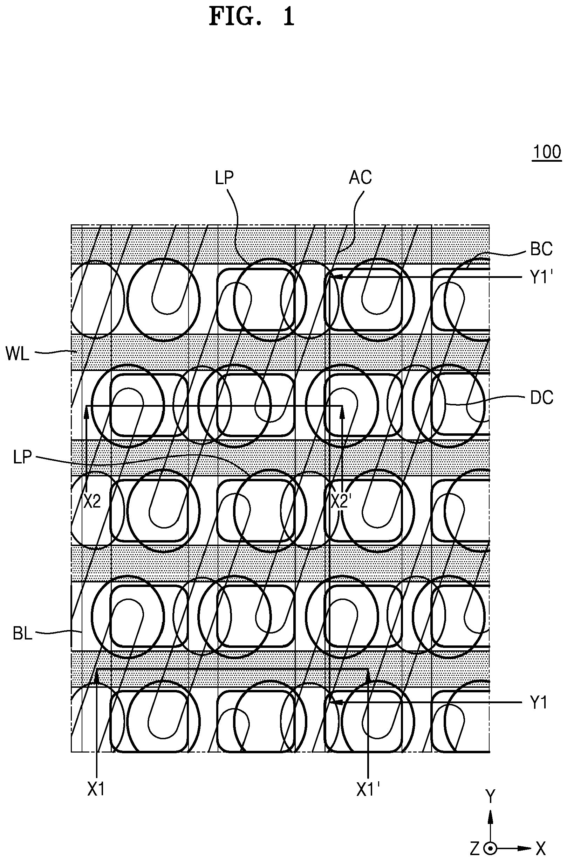

FIG. 1 is a layout diagram of a memory cell array region of an integrated circuit (IC) device 100 according to some embodiments of the present inventive concept. Although not shown in FIG. 1, the IC device 100 may include various components in addition to those shown in FIG. 1.

Referring to FIG. 1, the IC device 100 may include a plurality of active regions AC, which extend longitudinally in an oblique direction with respect to each of a first lateral direction (also referred to as a first horizontal direction and, for example, X direction) and a second lateral direction (also referred to as a second horizontal direction and, for example, Y direction) on an X-Y plane. A plurality of word lines WL may intersect the plurality of active regions AC and extend longitudinally in the first lateral direction (e.g., X direction). Each of the plurality of word lines WL may have a substantially constant width in the second lateral direction along the first lateral direction (e.g., X direction).

On the plurality of word lines WL, a plurality of bit lines BL may extend parallel to each other longitudinally in the second lateral direction (e.g., Y direction). The plurality of bit lines BL may be connected to the plurality of active regions AC through the direct contacts DC.

A plurality of buried contacts BC may be between two adjacent ones of the plurality of bit lines BL. A plurality of conductive landing pads LP may be on the plurality of buried contacts BC, respectively. The plurality of buried contacts BC and the plurality of conductive landing pads LP may connect a lower electrode of a capacitor formed on the plurality of bit lines BL to the active region AC. At least a portion of each of the plurality of conductive landing pads LP may overlap the buried contact BC.

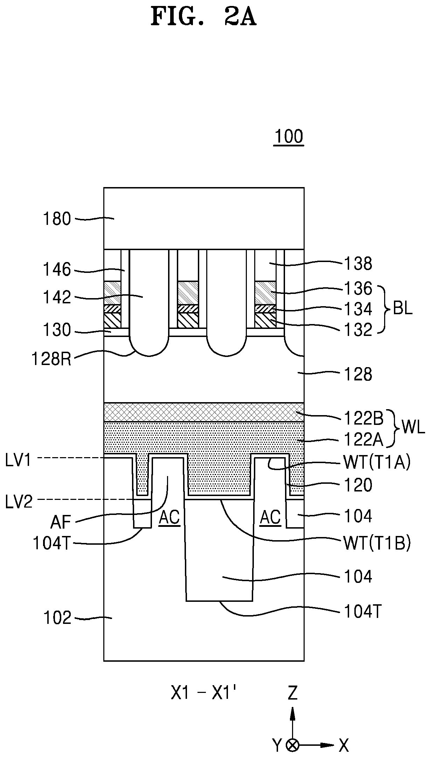

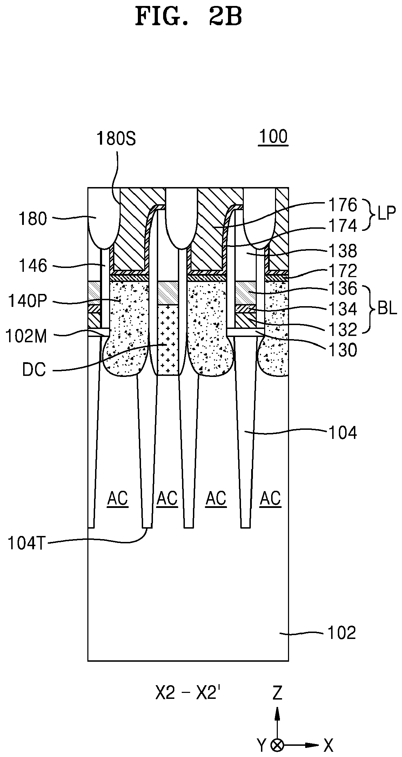

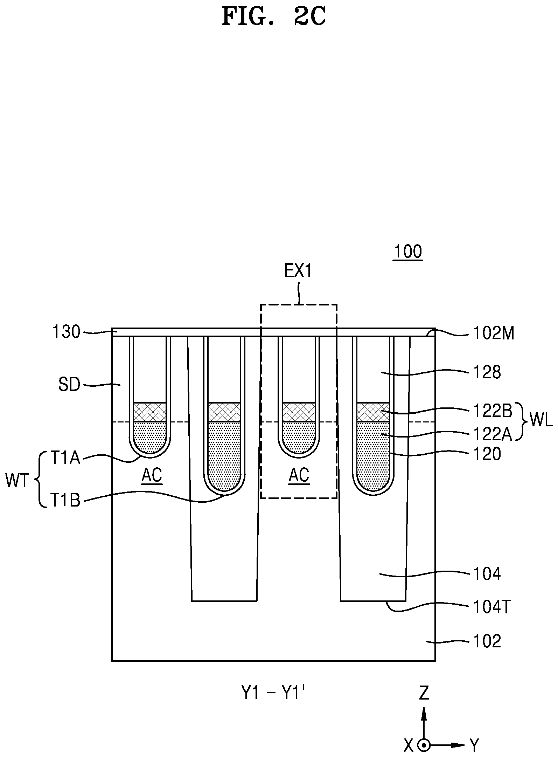

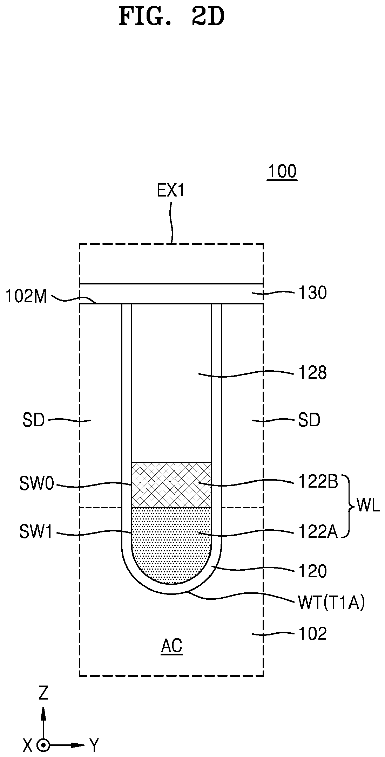

FIGS. 2A to 2D are cross-sectional views of the IC device 100 according to some embodiments of the present inventive concept. FIG. 2A is a cross-sectional view taken along a line X1 - X1' of FIG. 1. FIG. 2B is a cross-sectional view taken along a line X2 - X2' of FIG. 1. FIG. 2C is a cross-sectional view taken along a line Y1 - Y1' of FIG. 1. FIG. 2D is an enlarged cross-sectional view of a portion "EX1" of FIG. 2C. Although not shown in FIGS. 2A to 2D, the IC device 100 may include various components in addition to those shown in FIGS. 2A to 2D.

Referring to FIGS. 2A to 2D, the IC device 100 may include a substrate 102 in which a device isolation trench 104T is formed. The device isolation trench 104T may be filled by a device isolation film 104. A plurality of active regions AC may be defined by the device isolation trench 104T and the device isolation film 104 in the substrate 102.

The device isolation film 104 may surround the plurality of active regions AC on the substrate 102. The device isolation film 104 may include, for example, a silicon oxide film, a silicon nitride film, or a combination thereof. A vertical level of a bottom surface of the device isolation trench 104T or a depth of the device isolation trench 104T may vary according to a width of the device isolation trench 104T in a lateral direction (e.g., the first lateral direction or the second lateral direction). As the width of the device isolation trench 104T in the lateral direction increases, the vertical level of the bottom surface of the device isolation trench 104T may be farther from a main surface 102M of the substrate 102. As used herein, the term "vertical level" refers to a distance from the main surface 102M of the substrate 102 in a vertical direction (e.g., Z direction or -Z direction).

The substrate 102 may include, for example, silicon (e.g., single crystalline silicon, polycrystalline silicon, or amorphous silicon). In some other embodiments, the substrate 102 may include at least one selected from germanium (Ge), silicon germanium (SiGe), silicon carbide (SiC), gallium arsenide (GaAs), indium arsenide (InAs), and indium phosphide (InP). In some embodiments, the substrate 102 may include a conductive region, for example, a doped well or a doped structure.

A plurality of word line trenches WT may be formed in the substrate 102 and extend parallel to each other in the first lateral direction (e.g., X direction). Each of the plurality of word line trenches WT may have a line shape, which intersects with the plurality of active regions AC and the device isolation film 104 and extends longitudinally in the first lateral direction (e.g., X direction). The inside of each of the plurality of word line trenches WT may be filled by a gate dielectric film 120, the word line WL, and the insulating capping pattern 128.

As shown in FIG. 2A, each of the plurality of word line trenches WT includes first portions of a bottom surface on the plurality of active regions AC, which may be at a higher vertical level than second portions of the bottom surface on the device isolation film 104. Accordingly, a bottom profile of each of the plurality of word line trenches WT may have a concavo-convex shape, and a bottom surface of the word line WL may have a concavo-convex shape corresponding to the bottom profile of the word line trench WT. A plurality of fin areas AF may be formed in the plurality of active regions AC. The plurality of fin areas AF may protrude upward in the vertical direction (e.g., Z direction) toward the word line WL under the word line WL to correspond to the bottom profile of the word line trench WT.

As shown in FIGS. 2A and 2C, the plurality of word line trenches WT may include a first trench portion T1A and a second trench portion T1B. The first trench portion T1A may be in the substrate 102 and have a lowermost surface at a first vertical level LV1. The second trench portion T1B may be in the device isolation film 104 and have a lowermost surface at a second vertical level LV2. The second vertical level LV2 may be lower than the first vertical level LV1.

The gate dielectric film 120 may conformally cover an inner surface of the word line trench WT to contact the plurality of active regions AC and the device isolation film 104. The gate dielectric film 120 may include, for example, a silicon oxide film (e.g., a SiOz film). The gate dielectric film 120 may have a thickness of, for example, about 10 nm to about 30 nm, without being limited thereto.

Each of the plurality of word lines WL may fill a lower space (also referred to as a lower portion), which is a first portion of the word line trench WT, on the gate dielectric film 120 and extend longitudinally in the first lateral direction (e.g., X direction). Each of the insulating capping pattern 128 may fill an upper space (also referred to as an upper portion), which is a second portion of the word line trench WT, on a corresponding one of the plurality of word lines WL and extend longitudinally in the first lateral direction (e.g., X direction). The first portion and the second portion of the word line trench WT are different portions.

As shown in FIGS. 2A, 2C, and 2D, each of the plurality of word lines WL may include a first conductive plug 122A and a work-function control conductive plug 122B, which overlap each other in the vertical direction (e.g., Z direction). In the vertical direction (e.g., Z direction), the work-function control conductive plug 122B may be between the first conductive plug 122A and the insulating capping pattern 128. The first conductive plug 122A may be spaced apart from the insulating capping pattern 128 in the vertical direction (e.g., Z direction) with the work-function control conductive plug 122B therebetween. A top surface of the work-function control conductive plug 122B may be in contact with a bottom surface of the insulating capping pattern 128, and a bottom surface of the work-function control conductive plug 122B may be in contact with a top surface of the first conductive plug 122A. As used herein, the top surface of the work-function control conductive plug 122B may be referred to as a gate top surface, and the top surface of the first conductive plug 122A may be referred to as a first top surface. As used herein, "an element A vertically overlapping an element B" (or similar language) means that at least one vertical line can be drawn that intersects both elements A and B. As used herein, "a bottom surface" refers to a surface facing the substrate 102, and "a top surface" refers to a surface opposite the lower surface. The top surface may also be referred to as an upper surface, and the bottom surface may also be referred to as a lower surface.

In some embodiments, in each of the plurality of word lines WL, the first conductive plug 122A may include, for example, an undoped conductive metal nitride. For instance, the first conductive plug 122A may include, for example, an undoped titanium nitride (TiN) plug. As used herein, "an undoped element or layer" refers to an element or layer that does not include and thus is devoid of dopants intentionally added thereto. For example, an undoped element/layer of the first conductive plug 122A may not include a metal dopant (e.g., lanthanum (La)) included in the work-function control conductive plug 122B. In some embodiments, an undoped element/layer of the first conductive plug 122A may be devoid of a metal dopant (e.g., lanthanum (La)) included in the work-function control conductive plug 122B. In one example, the undoped element/layer of the first conductive plug 122A includes only a single material and can be referred to as a monolithic layer.

The first conductive plug 122A may include a pair of sidewalls SW1, which are opposite to each other and are spaced apart from each other in the second lateral direction (e.g., Y direction) and are each in contact with the gate dielectric film 120. The first conductive plug 122A may have a structure that fills the word line trench WT between the pair of sidewalls S W1 without being cut off in the second lateral direction (e.g., Y direction). In some embodiments, the first conductive plug 122A may contact the pair of sidewalls SW1 and may extend continuously between the pair of sidewalls SW1 in the second lateral direction (e.g., Y direction), as illustrated in FIG. 2D. As used herein, the sidewalls SW1 of the first conductive plug 122A may be referred to as first sidewalls. Among surfaces of the first conductive plug 122A, surfaces other than a top surface contacting the bottom surface of the work-function control conductive plug 122B may be in contact with the gate dielectric film 120.

In some embodiments, in each of the plurality of word lines WL, the work-function control conductive plug 122B may include a conductive metal nitride including a metal dopant. The conductive metal nitride may be doped with the metal dopant. For example, the work-function control conductive plug 122B may include a TiN plug including lanthanum (La) as a dopant. A layer including a dopant may be formed by doping the layer with the dopant.

The work-function control conductive plug 122B may have a pair of sidewalls SW0, which are opposite to each other and are spaced apart from each other in the second lateral direction (e.g., Y direction) and are each in contact with the gate dielectric film 120. The work-function control conductive plug 122B may have a structure that fills the word line trench WT between the pair of sidewalls SW0 without being cut off in the second lateral direction (e.g., Y direction). In some embodiments, the work-function control conductive plug 122B may contact the pair of sidewalls SW0 and may extend continuously between the pair of sidewalls SW0 in the second lateral direction (e.g., Y direction), as illustrated in FIG. 2D. As used herein, the sidewalls SW0 of the work-function control conductive plug 122B may be referred to as upper sidewalls or upper portions of sidewalls.

In the IC device 100 shown in FIGS. 2A to 2D, the first conductive plug 122A may be surrounded by (e.g., be contacted by) only the work-function control conductive plug 122B and the gate dielectric film 120. Stated differently, the work-function control conductive plug 122B and the gate dielectric film 120 completely enclose the first conductive plug 122A when viewed in cross-section. As shown in FIGS. 2A and 2C, a length of portions of the first conductive plug 122A, which vertically overlap the plurality of active regions AC in the vertical direction (e.g., Z direction), may be shorter than a length of portions of the first conductive plug 122A, which vertically overlap the device isolation film 104 in the vertical direction (e.g., Z direction). The top surface of the first conductive plug 122A may extend planar without a step in the first lateral direction (e.g., X direction), and a bottom surface of the first conductive plug 122A may extend in a concavo-convex shape in the first lateral direction (e.g., X direction).

A bottom surface of the work-function control conductive plug 122B may be in contact with a single layer. As used herein, the single layer may refer to a single film or a single pattern entirely including (i.e., consisting of) one type of material and may be also referred to as a monolithic layer that includes only a single material. In the IC device 100 shown in FIGS. 2A to 2D, the bottom surface of the work-function control conductive plug 122B may be in contact with only the first conductive plug 122A including a conductive metal nitride film. In this example, the first conductive plug 122A can be considered to be a monolithic layer.

The sidewall SW1 of the first conductive plug 122A and the sidewall SW0 of the work-function control conductive plug 122B may extend along a single planar surface without a step in a portion adjacent to an interface between the first conductive plug 122A and the work-function control conductive plug 122B. Stated differently, the sidewall SW1 of the first conductive plug 122A and the sidewall SW0 of the work-function control conductive plug 122B may include respective portions adjacent to the interface between the first conductive plug 122A and the work-function control conductive plug 122B, and those portions are on the same plane as illustrated in FIG. 2D. As shown in FIGS. 2C and 2D, the sidewall SW1 of the first conductive plug 122A and the sidewall SW0 of the work-function control conductive plug 122B may include a portion extending in a straight line passing through the interface between the first conductive plug 122A and the work-function control conductive plug 122B.

Although FIGS. 2A, 2B, and 2C illustrate an example in which a length of the work-function control conductive plug 122B in the vertical direction (e.g., Z direction) is less than a length of the first conductive plug 122A in the vertical direction (e.g., Z direction) in one word line WL, the inventive concept is not limited thereto. For example, in one word line WL, the length of the work-function control conductive plug 122B may be equal to or greater than the length of the first conductive plug 122A in the vertical direction (e.g., Z direction). In one word line WL, the length of each of the first conductive plug 122A and the work-function control conductive plug 122B in the vertical direction (e.g., Z direction) may be variously adjusted as needed.

The insulating capping pattern 128 may fill the remaining space of the word line trench WT on the word line WL. In some embodiments, the insulating capping pattern 128 may include, for example, a silicon nitride film, a silicon oxynitride film, a silicon oxide film, or a combination thereof. In some embodiments, the insulating capping pattern 128 may include a silicon nitride film. In some other embodiments, the insulating capping pattern 128 may include, for example, a silicon oxide film and a silicon nitride film. The silicon oxide film may cover the top surface of the work-function control conductive plug 122B and at least a portion of a surface of the gate dielectric film 120. The silicon nitride film may fill an upper space of the word line trench WT on the silicon oxide film.

In the plurality of active regions AC, a plurality of source/drain regions SD may be on both sides of the plurality of word lines WL. Each of the plurality of source/drain regions SD may include an impurity region including impurity ions implanted into the substrate 102. The sidewalls SW0 of the work-function control conductive plug 122B may respectively face a pair of source/drain regions SD, which are on both sides of the gate dielectric film 120 in the second lateral direction (e.g., Y direction).

In each of the plurality of word lines WL included in the IC device 100, the first conductive plug 122A may include, for example, an undoped TiN film, and the work-function control conductive plug 122B may include, for example, a TiN film including lanthanum (La) as a dopant. In some embodiments, lanthanum (La) may be included at a content of, for example, about 0.01 atomic percent (at%) to about 10 at% in the work-function control conductive plug 122B, without being limited thereto. A work function of the work-function control conductive plug 122B may be lower than a work function of the first conductive plug 122A. In some embodiments, the work function of the work-function control conductive plug 122B may be lower than the work function of the first conductive plug 122A by about 300 mV to about 500 mV, for example, about 400 mV to about 450 mV. Thus, each of the plurality of word lines WL may have a dual work function structure.

More specifically, when the first conductive plug 122A includes an undoped TiN film and the work-function control conductive plug 122B includes a TiN film including lanthanum (La) as a dopant, La atoms may be distributed in the TiN film in the work-function control conductive plug 122B, and thus, a chemical bonding structure of the TiN film including the La atoms as a dopant may have a different structure from that of the undoped TiN film. Accordingly, a work function of the TiN film including the La atoms as a dopant may be different from a work function of the undoped TiN film. The work function of the TiN film including the La atoms as a dopant may be lower than the work function of the undoped TiN film. As a content ratio of La atoms in the TiN film including the La atoms as a dopant increases, the work function of the TiN film including the La atoms as a dopant may be further smaller.

As used herein, each of the work function of the work-function control conductive plug 122B and the work function of the first conductive plug 122A may refer to an effective work function. The effective work function may refer to a work function modified by the influence of a bonding interface between each of the work-function control conductive plug 122B and the first conductive plug 122A and a silicon oxide film in a structure in which each of the work-function control conductive plug 122B and the first conductive plug 122A is in contact with the silicon oxide film.

Each of the plurality of word lines WL may have a structure in which the work function of the work-function control conductive plug 122B is lower than the work function of the first conductive plug 122A, and thus, each of the plurality of word lines WL may have a dual work function structure. In addition, because the work-function control conductive plug 122B having a relatively low work function is on the first conductive plug 122A having a relatively high work function, the work-function control conductive plug 122B having the relatively low work function may be more adjacent to the source/drain region SD than the first conductive plug 122A. Accordingly, the word line WL may have a structure in which, as compared to the first conductive plug 122A, the work-function control conductive plug 122B has a greater area overlapping the source/drain region SD including an impurity region in a lateral direction (e.g., the first horizontal direction or the second horizontal direction). Therefore, a gate induced drain leakage (GIDL) current may decrease or may be prevented from increasing in the IC device 100, and a reduction in data retention time may decrease or may be prevented, thereby improving refresh characteristics.

Furthermore, in each of the plurality of word lines WL included in the IC device 100, the work-function control conductive plug 122B having the relatively low work function may not have the liner structure located only in the local region adjacent to the gate dielectric film 120 in the second lateral direction (e.g., Y direction) but a plug structure extending over the entire width of the word line WL in the second lateral direction (e.g., Y direction). Thus, a volume occupied by the work-function control conductive plug 122B having the relatively low work function in the work line WL may be increased. Therefore, in the IC device 100, refresh characteristics may be further improved compared to a case in which the work-function control conductive plug 122B has a liner structure located only in a local region adjacent to the gate dielectric film 120.

Moreover, in each of the plurality of word lines WL included in the IC device 100, because the first conductive plug 122A has a relatively low resistivity and a relatively high work function, a resistance of the word line WL may be reduced, and a threshold voltage targeted by a transistor may be precisely controlled. Accordingly, the IC device 100 may ensure stable electrical characteristics.

In addition, each of the plurality of word lines WL included in the IC device 100 may include only a metal-containing structure and may not include a material (e.g., polysilicon) having a relatively high resistance. Therefore, a volume occupied by a metal in each of the plurality of word lines WL may be increased, and thus, resistances of the plurality of word lines WL may be reduced.

As shown in FIGS. 2A to 2C, the main surface 102M of the substrate 102, the device isolation film 104, and the insulating capping pattern 128 may be covered by a buffer insulating film 130. The buffer insulating film 130 may include, for example, an oxide film, a nitride film, or a combination thereof. As shown in FIG. 2B, a plurality of direct contacts DC may be respectively on partial regions of the plurality of active regions AC. As shown in FIGS. 2A and 2B, a plurality of bit lines BL may extend longitudinally in the second lateral direction (e.g., Y direction) on the buffer insulating film 130 and the plurality of direct contacts DC. The plurality of bit lines BL may be covered by a plurality of insulating capping patterns 138.

A plurality of conductive plugs 140P and a plurality of insulating fences 142 may be alternately arranged one-by-one in a line in the second lateral direction (e.g., Y direction) between a pair of bit lines BL, which are adjacent to each other from among the plurality of bit lines BL. The plurality of insulating fences 142 may fill a plurality of recesses 128R formed in the top surface of the insulating capping pattern 128 and may be respectively arranged one-by-one between the plurality of conductive plugs 140P. In the second lateral direction (e.g., Y direction), both sidewalls of the plurality of conductive plugs 140P may be respectively covered by the plurality of insulating fences 142. The plurality of conductive plugs 140P, which are arranged in a line in the second lateral direction (e.g., Y direction), may be insulated from each other by the plurality of insulating fences 142. The plurality of conductive plugs 140P may constitute the plurality of buried contacts BC shown in FIG. 1.

Each of the plurality of bit lines BL may be connected to the active region AC through the direct contact DC. One direct contact DC and a pair of conductive plugs 140P, which face each other with the one direct contact DC therebetween, may be connected to respectively different active regions AC, from among the plurality of active regions AC. In some embodiments, the direct contact DC may include, for example, silicon (Si), germanium (Ge), tungsten (W), tungsten nitride (WN), cobalt (Co), nickel (Ni), aluminum (Al), molybdenum (Mo), ruthenium (Ru), titanium (Ti), titanium nitride (TiN), tantalum (Ta), tantalum nitride (TaN), copper (Cu), or a combination thereof. For example, the direct contact DC may include an epitaxial silicon layer.

Each of the plurality of bit lines BL may include a lower conductive layer 132, a middle conductive layer 134, and an upper conductive layer 136, which are sequentially formed on the substrate 102. A top surface of the lower conductive layer 132 may extend coplanar with a top surface of the direct contact DC. FIGS. 2A and 2B illustrate an example in which each of the plurality of bit lines BL has a triple structure including the lower conductive layer 132, the middle conductive layer 134, and the upper conductive layer 136, but the inventive concept is not limited thereto. For example, each of the plurality of bit lines BL may be formed as a single layer, a double layer, or a stacked structure of four or more layers. In some embodiments, the lower conductive layer 132 may include, for example, conductive polysilicon. Each of the middle conductive layer 134 and the upper conductive layer 136 may include, for example, titanium nitride (TiN), titanium silicon nitride (TiSiN), tungsten (W), tungsten silicide, or a combination thereof. For example, the middle conductive layer 134 may include TiN and/or TiSiN, and the upper conductive layer 136 may include W. The plurality of insulating capping patterns 138 may include a silicon nitride film.

Each of the plurality of conductive plugs 140P may have a pillar shape that extends in the vertical direction (e.g., Z direction) along a space between the plurality of bit lines BL on the substrate 102. A bottom surface of each of the plurality of conductive plugs 140P may be in contact with the active region AC. A portion of each of the plurality of conductive plugs 140P may be at a lower level than the main surface 102M of the substrate 102. The plurality of conductive plugs 140P may include, for example, doped polysilicon, metal, conductive metal nitride, or a combination thereof.

Each of the plurality of insulating fences 142 may have a pillar shape extending in the vertical direction (e.g., Z direction) between two adjacent ones of the plurality of bit lines BL. The plurality of insulating fences 142 may include, for example, a silicon nitride film.

Both sidewalls of the plurality of bit lines BL, the plurality of insulating capping patterns 138, and the plurality of direct contacts DC may be respectively covered by a plurality of insulating spacers 146. The plurality of insulating spacers 146 may extend longitudinally parallel to the plurality of bit lines BL in the second lateral direction (e.g., Y direction) on the both sidewalls of the plurality of bit lines BL. The plurality of insulating spacers 146 may include, for example, an oxide film, a nitride film, air spacers, or a combination thereof. As used herein, the term "air" may refer to space including the atmosphere or other gases that may be in the atmosphere or during a manufacturing process.

Each of the plurality of conductive plugs 140P may be spaced apart from the bit line BL in the first lateral direction (e.g., X direction) with the insulating spacer 146 therebetween. Each of the plurality of insulating fences 142 may be spaced apart from the bit line BL with the insulating spacer 146 therebetween in the first lateral direction (e.g., X direction).

A metal silicide film 172 and a conductive landing pad LP may be sequentially formed on the conductive plug 140P. The metal silicide film 172 and the conductive landing pad LP may vertically overlap the conductive plug 140P. Each of a plurality of metal silicide films 172 may be between the conductive plug 140P and the conductive landing pad LP and be spaced apart from the bit line BL with the insulating spacer 146 therebetween. The metal silicide film 172 may include, for example, cobalt silicide, nickel silicide, or manganese silicide.

Each of a plurality of conductive landing pads LP may be connected to the conductive plug 140P through the metal silicide film 172. The plurality of conductive landing pads LP may extend from respective spaces between the plurality of insulating capping patterns 138 to respective upper spaces of the plurality of insulating capping patterns 138 to vertically overlap portions of the plurality of bit lines BL. Each of the plurality of conductive landing pads LP may include a conductive barrier film 174 and a conductive layer 176. The conductive barrier film 174 may include, for example, titanium (Ti), titanium nitride (TiN), or a combination thereof. The conductive layer 176 may include, for example, a metal, a metal nitride, conductive polysilicon, or a combination thereof. For example, the conductive layer 176 may include tungsten (W).

The plurality of conductive landing pads LP may have a plurality of island-type pattern shapes in a view from above. The plurality of conductive landing pads LP may be electrically insulated from each other by an insulating film 180 filling insulating spaces 180S, which are around the plurality of conductive landing pads LP. The insulating film 180 may include, for example, a silicon nitride film, a silicon oxide film, or a combination thereof.

In the IC device 100 shown in FIGS. 2A to 2D, each of the plurality of word lines WL may include only a metal-containing structure including the first conductive plug 122A and the work-function control conductive plug 122B and be configured to provide a dual work function. Accordingly, resistances of the plurality of word lines WL may be reduced, and an increase in GIDL current and a reduction in data retention time may decrease or may be prevented in the IC device 100. Thus, refresh characteristics may be improved, and stable electrical characteristics may be ensured.

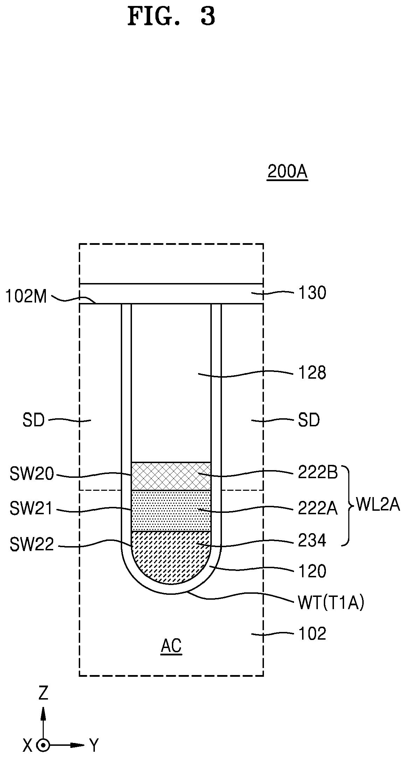

FIG. 3 is a cross-sectional view of an IC device 200A according to some embodiments of the present inventive concept. FIG. 3 illustrates an enlarged cross-sectional configuration of a portion corresponding to region "EX1" of FIG. 2C in the IC device 200A. In FIG. 3, the same reference numerals are used to denote the same elements as in FIGS. 2A to 2D, and repeated descriptions thereof are omitted.

Referring to FIG. 3, the IC device 200A may have the substantially same configuration as the IC device 100 described with reference to FIGS. 1 and 2A to 2D. However, the IC device 200A may include a word line WL2A instead of a word line WL.

The word line WL2A may fill a lower space (also referred to as a lower portion), which is a portion of the word line trench WT, on the gate dielectric film 120 and extend longitudinally in a first lateral direction (e.g., X direction). The word line WL2A may include a work-function control conductive plug 222B, a first conductive plug 222A, and a second conductive plug 234, which overlap each other in a vertical direction (e.g., Z direction). The second conductive plug 234 may be farther from the work-function control conductive plug 222B than the first conductive plug 222A.

The first conductive plug 222A and the second conductive plug 234 may include different materials from each other. The first conductive plug 222A may include, for example, an undoped conductive metal nitride, and the second conductive plug 234 may include a single metal. The work-function control conductive plug 222B may include, for example, a conductive metal nitride including a metal dopant. In some embodiments, a work function of the metal included in the second conductive plug 234 may be higher than a work function of the conductive metal nitride included in the first conductive plug 222A.

The first conductive plug 222A and the work-function control conductive plug 222B may substantially have the same configurations as the first conductive plug 122A and the work-function control conductive plug 122B, respectively, which have been described with reference to FIGS. 2A, 2C, and 2D. However, the first conductive plug 222A may be between the second conductive plug 234 and the work-function control conductive plug 222B in the vertical direction (e.g., Z direction), and a bottom surface of the first conductive plug 222A may be spaced apart from the gate dielectric film 120 in the vertical direction (e.g., Z direction) with the second conductive plug 234 therebetween. The bottom surface of the first conductive plug 222A may be in contact with a single layer. The bottom surface of the first conductive plug 222A may be in contact with a top surface of the second conductive plug 234 including a single metal. As used herein, "a single metal" may refer to a single metal layer or a monolithic metal layer including only one metallic material.

The work-function control conductive plug 222B, the first conductive plug 222A, and the second conductive plug 234 may be at different vertical distances from each other from the main surface 102M of the substrate 102. In the vertical direction (e.g., Z direction), a shortest distance from the main surface 102M of the substrate 102 to the first conductive plug 222A may be greater than a shortest distance from the main surface 102M of the substrate 102 to the work-function control conductive plug 222B, and a shortest distance from the main surface 102M of the substrate 102 to the second conductive plug 234 may be greater than the shortest distance from the main surface 102M of the substrate 102 to the first conductive plug 222A. In a lateral direction (e.g., the first lateral direction (e.g., X direction) and a second lateral direction (e.g., Y direction)), the work-function control conductive plug 222B, the first conductive plug 222A, and the second conductive plug 234 may be arranged so as not to face each other.

The second conductive plug 234 may be spaced apart from the insulating capping pattern 128 in the vertical direction (e.g., Z direction) with the first conductive plug 222A and the work-function control conductive plug 222B therebetween. The second conductive plug 234 may be spaced apart from the work-function control conductive plug 222B in the vertical direction (e.g., Z direction) with the first conductive plug 222A therebetween.

The second conductive plug 234 may have a top surface in contact with the bottom surface of the first conductive plug 222A. The second conductive plug 234 may have a pair of sidewalls SW22, which are opposite to each other and are spaced apart from each other in the second lateral direction (e.g., Y direction) and are each in contact with the gate dielectric film 120. The second conductive plug 234 may have a structure that fills the word line trench WT between the pair of sidewalls SW22 without being cut off in the second lateral direction (e.g., Y direction). In some embodiments, the second conductive plug 234 may contact the pair of sidewalls SW22 and may extend continuously between the pair of sidewalls SW22 in the second lateral direction (e.g., Y direction), as illustrated in FIG. 3. As used herein, the top surface of the second conductive plug 234 may be referred to as a second top surface, and a sidewall of the second conductive plug 234 may be referred to as a second sidewall.

From among surfaces of the second conductive plug 234, surfaces other than the top surface in contact with the bottom surface of the first conductive plug 222A may be in contact with the gate dielectric film 120. A bottom surface of the second conductive plug 234 may extend in a concavo-convex shape in the first lateral direction (e.g., X direction). In some embodiments, the second conductive plug 234 may include, for example, a molybdenum (Mo) plug.

In the IC device 200A, a sidewall SW20 of the work-function control conductive plug 222B, a sidewall SW21 of the first conductive plug 222A, and the sidewall SW22 of the second conductive plug 234 may extend along one planar surface without a step in each of a portion adj acent to an interface between the work-function control conductive plug 222B and the first conductive plug 222A and a portion adjacent to an interface between the first conductive plug 222A and the second conductive plug 234. In the word line WL2A, a length of each of the work-function control conductive plug 222B, the first conductive plug 222A, and the second conductive plug 234 in the vertical direction (e.g., Z direction) is not limited to that shown in FIG. 3 but may be variously adjusted as needed.

In some embodiments, the work-function control conductive plug 222B may include, for example, TiN including lanthanum (La) as a dopant, the first conductive plug 222A may include, for example, undoped TiN, and the second conductive plug 234 may include, for example, molybdenum (Mo). Molybdenum (Mo) may provide a higher work function than TiN. Because the word line WL2A includes the second conductive plug 234 including molybdenum (Mo), a resistance of the word line WL2A may be reduced, a threshold voltage targeted by a transistor may be precisely controlled, and the IC device 200A may ensure stable electrical characteristics.

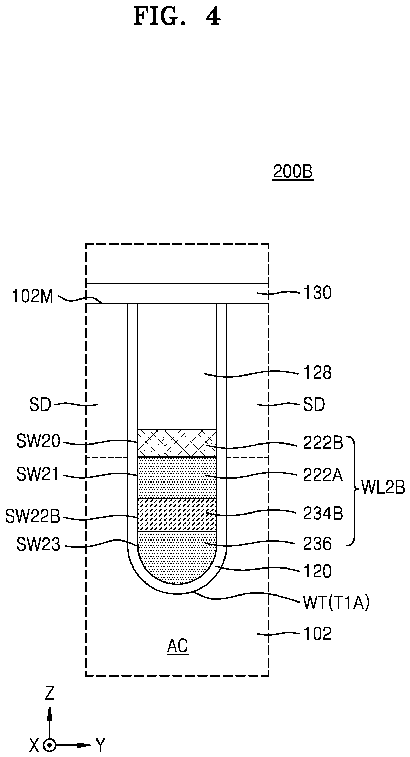

FIG. 4 is a cross-sectional view of an IC device 200B according to some embodiments of the present inventive concept. FIG. 4 illustrates an enlarged cross-sectional configuration of a portion corresponding to region "EX1" of FIG. 2C in the IC device 200B. In FIG. 4, the same reference numerals are used to denote the same elements as in FIGS. 2A to 2D and 3, and repeated descriptions thereof are omitted.

Referring to FIG. 4, the IC device 200B may have the substantially same configuration as the IC device 200A described with reference to FIG. 3. However, the IC device 200B may include a word line WL2B instead of the word line WL2A.

The word line WL2B may fill a lower space (also referred to as a lower portion), which is a portion of the word line trench WT, on the gate dielectric film 120 and extend longitudinally in a first lateral direction (e.g., X direction). The word line WL2B may include a work-function control conductive plug 222B, a first conductive plug 222A, a second conductive plug 234B, and a third conductive plug 236, which overlap each other in a vertical direction (e.g., Z direction).

In the IC device 200B, the work-function control conductive plug 222B, the first conductive plug 222A, the second conductive plug 234B, and the third conductive plug 236 may be at different vertical distances from each other from a main surface 102M of the substrate 102. The first conductive plug 222A, the second conductive plug 234B, and the third conductive plug 236 may be spaced apart from the insulating capping pattern 128 in the vertical direction (e.g., Z direction) with the work-function control conductive plug 222B therebetween. The first conductive plug 222A, the second conductive plug 234B, and the third conductive plug 236 may be at different vertical distances from each other from the insulating capping pattern 128. In the vertical direction (e.g., Z direction), a shortest distance from the insulating capping pattern 128 to the second conductive plug 234B may be greater than a shortest distance from the insulating capping pattern 128 to the first conductive plug 222A, and a shortest distance from the insulating capping pattern 128 to the third conductive plug 236 may be greater than the shortest distance from the insulating capping pattern 128 to the second conductive plug 234B. In a lateral direction (e.g., the first lateral direction (e.g., X direction) and a second lateral direction (e.g., Y direction)), the work-function control conductive plug 222B, the first conductive plug 222A, the second conductive plug 234B, and the third conductive plug 236 may be arranged so as not to face each other.

The first conductive plug 222A and the work-function control conductive plug 222B may have the same configurations as described with reference to FIG. 3. The second conductive plug 234B may have the substantially same configuration as the second conductive plug 234 described with reference to FIG. 3. However, the first conductive plug 222A may be between the second conductive plug 234B and the work-function control conductive plug 222B in the vertical direction (e.g., Z direction), and the first conductive plug 222A may be spaced apart from the gate dielectric film 120 in the vertical direction (e.g., Z direction) with the second conductive plug 234B and the third conductive plug 236 therebetween. The first conductive plug 222A and the third conductive plug 236 may be spaced apart from each other in the vertical direction (e.g., Z direction) with the second conductive plug 234B therebetween.

The second conductive plug 234B may have a top surface in contact with the bottom surface of the first conductive plug 222A and a bottom surface in contact with a top surface of the third conductive plug 236. The bottom surface of the second conductive plug 234B may be spaced apart from the gate dielectric film 120 in the vertical direction (e.g., Z direction) with the third conductive plug 236 therebetween. The bottom surface of the second conductive plug 234B may be in contact with a single layer. The bottom surface of the second conductive plug 234B may be in contact with the top surface of the third conductive plug 236 including a conductive metal nitride.

Each of the first conductive plug 222A and the third conductive plug 236 may include, for example, an undoped conductive metal nitride. In some embodiments, the first conductive plug 222A may include the same material as the third conductive plug 236. In some embodiments, each of the first conductive plug 222A and the third conductive plug 236 may include, for example, an undoped TiN plug.

The third conductive plug 236 may be spaced apart from the first conductive plug 222A in the vertical direction (e.g., Z direction) with the second conductive plug 234B therebetween, and the top surface of the third conductive plug 236 may be in contact with the bottom surface of the second conductive plug 234B. The third conductive plug 236 may have a pair of sidewalls SW23, which are opposite to each other and are spaced apart from each other in the second lateral direction (e.g., Y direction) and are each in contact with the gate dielectric film 120. The third conductive plug 236 may have a structure that fills the word line trench WT between the pair of sidewalls SW23 without being cut off in the second lateral direction (e.g., Y direction). In some embodiments, the third conductive plug 236 may contact the pair of sidewalls SW23 and may extend continuously between the pair of sidewalls SW23 in the second lateral direction (e.g., Y direction), as illustrated in FIG. 4 As used herein, the top surface of the third conductive plug 236 may be referred to as a third top surface. From among surfaces of the third conductive plug 236, surfaces other than the top surface in contact with the bottom surface of the second conductive plug 234B may be in contact with the gate dielectric film 120. A bottom surface of the third conductive plug 236 may extend in a concavo-convex shape in the first lateral direction (e.g., X direction).

In the IC device 200B, a sidewall SW20 of the work-function control conductive plug 222B, a sidewall SW21 of the first conductive plug 222A, a sidewall SW22B of the second conductive plug 234B, and the sidewall SW23 of the third conductive plug 236 may extend along one planar surface without a step in each of a portion adjacent to an interface between the work-function control conductive plug 222B and the first conductive plug 222A, a portion adjacent to an interface between the first conductive plug 222A and the second conductive plug 234B, and a portion adjacent to an interface between the second conductive plug 234B and the third conductive plug 236. In the word line WL2B, a length of each of the work-function control conductive plug 222B, the first conductive plug 222A, the second conductive plug 234B, and the third conductive plug 236 in the vertical direction (e.g., Z direction) is not limited to that shown in FIG. 4 and may be variously adjusted as needed.

In some embodiments, the work-function control conductive plug 222B may include, for example, TiN including lanthanum (La) as a dopant, each of the first conductive plug 222A and the third conductive plug 236 may include, for example, undoped TiN, and the second conductive plug 234 may include, for example, molybdenum (Mo). Molybdenum (Mo) may provide a higher work function than TiN. The word line WL2B may include the second conductive plug 234 including molybdenum (Mo) and the first conductive plug 222A and the third conductive plug 236, which are spaced apart from each other in the vertical direction (e.g., Z direction) with the second conductive plug 234 therebetween. Accordingly, a resistance of the word line WL2B may be reduced, a threshold voltage targeted by a transistor may be precisely controlled, and the IC device 200B may ensure stable electrical characteristics.

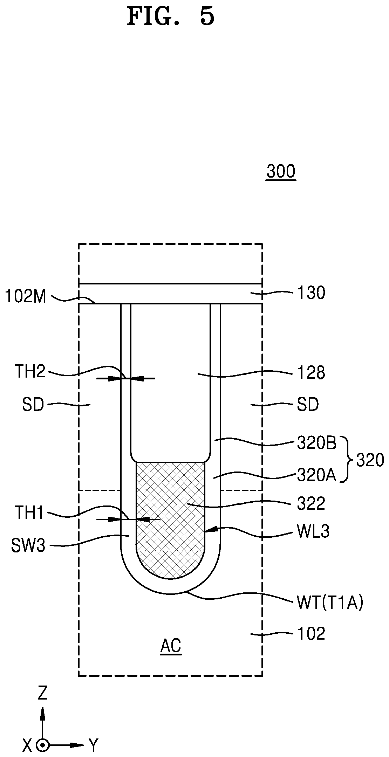

FIG. 5 is a cross-sectional view of an IC device 300 according to some embodiments of the present inventive concept. FIG. 5 illustrates an enlarged cross-sectional configuration of a portion corresponding to region "EX1" of FIG. 2C in the IC device 300. In FIG. 5, the same reference numerals are used to denote the same elements as in FIGS. 2A to 2D, and repeated descriptions thereof are omitted.

Referring to FIG. 5, the IC device 300 may have the substantially same configuration as the IC device 100 described with reference to FIGS. 1 and 2A to 2D. The IC device 300 may have the same plan layout configuration as shown in FIG. 1. However, the IC device 300 may include a gate dielectric film 320, a word line WL3, and an insulating capping pattern 128, which fill a word line trench WT.

The word line WL3 may fill a lower space (also referred to as a lower portion), which is a portion of the word line trench WT, on the gate dielectric film 320 and extend longitudinally in a first lateral direction (e.g., X direction). The word line WL3 may include only a work-function control conductive plug 322. The work-function control conductive plug 322 may have a top surface in contact with a bottom surface of the insulating capping pattern 128. From among surfaces of the work-function control conductive plug 322, surfaces other than the top surface in contact with the bottom surface of the insulating capping pattern 128 may be in contact with the gate dielectric film 320. In a second lateral direction (e.g., Y direction), a width of the work-function control conductive plug 322 may be less than a width of the insulating capping pattern 128.

The work-function control conductive plug 322 may have a pair of sidewalls SW3, which are opposite to each other and are spaced apart from each other in the second lateral direction (e.g., Y direction) and are each in contact with the gate dielectric film 320. The work-function control conductive plug 322 may have a structure that fills the word line trench WT between the pair of sidewalls SW23 without being cut off in the second lateral direction (e.g., Y direction). In some embodiments, the work-function control conductive plug 322 may contact the pair of sidewalls SW23 and may extend continuously between the pair of sidewalls SW23 in the second lateral direction (e.g., Y direction), as illustrated in FIG. 5. In some embodiments, the work-function control conductive plug 322 may include a TiN plug including lanthanum (La) as a dopant.

The gate dielectric film 320 may include a first portion 320A in contact with the sidewall SW3 of the work-function control conductive plug 322 and a second portion 320B in contact with the insulating capping pattern 128. In the second lateral direction (e.g., Y direction), a thickness TH1 of the first portion 320A of the gate dielectric film 320 may be greater than a thickness TH2 of the second portion 320B of the gate dielectric film 320. In some embodiments, the first portion 320A of the gate dielectric film 320 may include, for example, a combination of at least one selected from a titanium oxide film and a titanium lanthanum oxide film and a silicon oxide film, and the second portion 320B of the gate dielectric film 320 may include, for example, a silicon oxide film. In the first portion 320A of the gate dielectric film 320, at least one selected from the titanium oxide film and the titanium lanthanum oxide film may be between the silicon oxide film and the work-function control conductive plug 322.

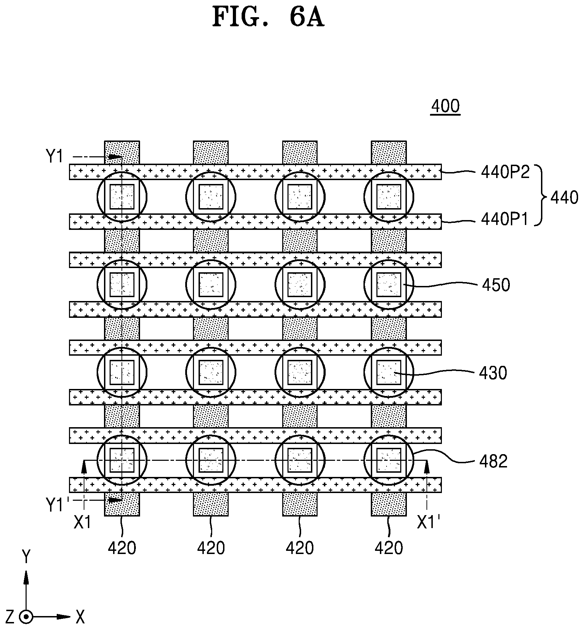

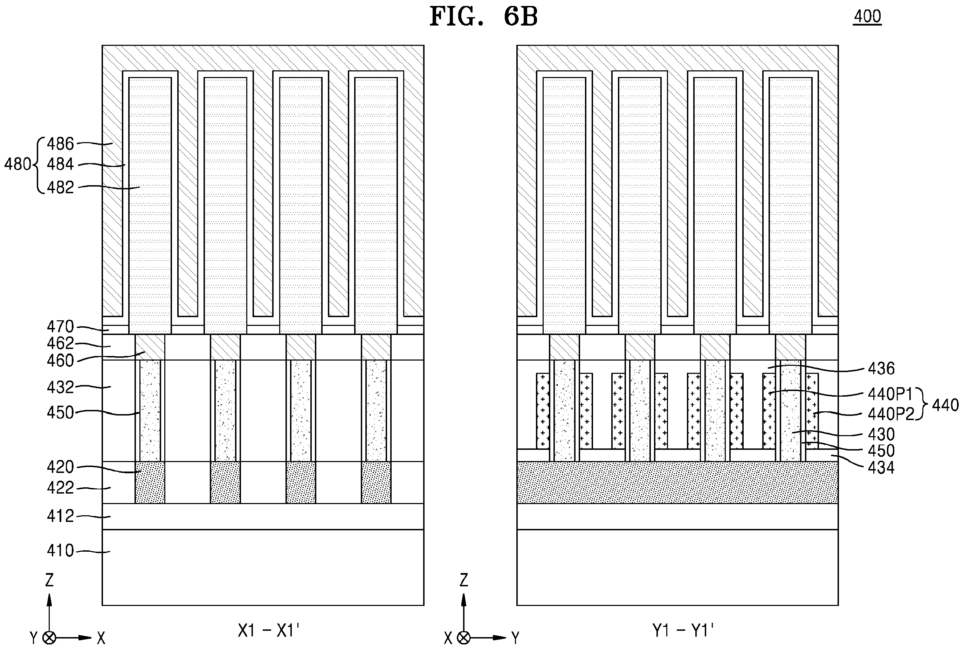

FIG. 6A is a layout diagram of an IC device 400 according to some embodiments of the present inventive concept, and FIG. 6B is a cross-sectional view taken along lines X1 - X1' and Y1 - Y1' of FIG. 6A.

Referring to FIGS. 6A and 6B, the IC device 400 may include a substrate 410, a plurality of first conductive lines 420, a channel layer 430, a gate electrode 440, a gate insulating layer 450, and a capacitor structure 480. The IC device 400 may include a memory device including a vertical channel transistor (VCT). The VCT may refer to having a structure in which a channel length of the channel layer 430 extends in a vertical direction from the substrate 410.

A lower insulating layer 412 may be on the substrate 410, and the plurality of first conductive lines 420 may be spaced apart from each other in the first lateral direction (e.g., X direction) on the lower insulating layer 412 and extend longitudinally in a second lateral direction (e.g., Y direction). On the lower insulating layer 412, a plurality of first insulating patterns 422 may fill spaces between the plurality of first conductive lines 420. The plurality of first insulating patterns 422 may extend longitudinally in the second lateral direction (e.g., Y direction), and top surfaces of the plurality of first insulating patterns 422 may be at the same vertical level as top surfaces of the plurality of first conductive lines 420. Each of the plurality of first conductive lines 420 may function as a bit line of the IC device 400.

In some embodiments, the plurality of first conductive lines 420 may include, for example, doped polysilicon, a metal, a conductive metal nitride, a conductive metal silicide, a conductive metal oxide, or a combination thereof. For example, the plurality of first conductive lines 420 may include doped polysilicon, aluminum (Al), copper (Cu), titanium (Ti), tantalum (Ta), ruthenium (Ru), tungsten (W), molybdenum (Mo), platinum (Pt), nickel (Ni), cobalt (Co), titanium nitride (TiN), tantalum nitride (TaN), tungsten nitride (WN), niobium nitride (NbN), titanium aluminide (TiAl), titanium aluminum nitride (TiAlN), titanium silicide (TiSi), titanium silicon nitride (TiSiN), tantalum silicide (TaSi), tantalum silicon nitride (TaSiN), ruthenium titanium nitride (RuTiN), nickel silicide (NiSi), cobalt silicide (CoSi), iridium oxide (IrOx), ruthenium oxide (RuOx), or a combination thereof, without being limited thereto. Each of the plurality of first conductive lines 420 may include a single layer or a multilayered structure of the materials described above. In some embodiments, the plurality of first conductive lines 420 may include a two-dimensional (2D) semiconductor material. The 2D semiconductor material may include graphene, carbon nanotubes, or a combination thereof.

Channel layers 430 may be arranged in a matrix form on the plurality of first conductive lines 420 and be spaced apart from each other in the first lateral direction (e.g., X direction) and the second lateral direction (e.g., Y direction). The channel layer 430 may have a first width in the first lateral direction (e.g., X direction) and a first height in the vertical direction (e.g., Z direction), and the first height may be greater than the first width. For example, the first height may be about twice to about 10 times the first width, without being limited thereto. A bottom portion of the channel layer 430 may function as a first source/drain region, an upper portion of the channel layer 430 may function as a second source/drain region, and a portion of the channel layer 430 between the first and second source/drain regions may function as a channel region.

In some embodiments, the channel layer 430 may include an oxide semiconductor. For example, the oxide semiconductor may include indium gallium zinc oxide (InGaZnO), indium gallium silicon oxide (InGaSiO), indium tin zinc oxide (InSnZnO), indium zinc oxide (InZnO), zinc oxide (ZnO), zinc tin oxide (ZnSnO), zinc oxynitride (ZnON), zirconium zinc tin oxide (ZrZnSnO), tin oxide (SnO), hafnium indium zinc oxide (HflnZnO), gallium zinc tin oxide (GaZnSnO), aluminum zinc tin oxide (AlZnSnO), YbGaZnO, InGaO, or a combination thereof. As used herein, the indication of each of materials listed above refers to a material including elements included therein, without referring to a chemical formula representing a stoichiometric relationship. The channel layer 430 may include a single layer or a multilayered structure of the oxide semiconductor. In some embodiments, the channel layer 430 may have a bandgap that is higher than the bandgap energy of silicon. For example, the channel layer 430 may have a bandgap energy of about 1.5 eV to about 5.6 eV. For example, the channel layer 430 may have an optimum channel performance when the channel layer 430 has a bandgap energy of about 2.0 eV to about 4.0 eV. For example, the channel layer 430 may be polycrystalline or amorphous, without being limited thereto. In some embodiments, the channel layer 430 may include a 2D semiconductor material. For example, the 2D semiconductor material may include graphene, carbon nanotubes, or a combination thereof.

The gate electrode 440 may extend in the first lateral direction (e.g., X direction) on both sidewalls of the channel layer 430. The gate electrode 440 may include a first sub-gate electrode 440P1 facing a first sidewall of the channel layer 430 and a second sub-gate electrode 440P2 facing a second sidewall that is opposite to the first sidewall of the channel layer 430. Because one channel layer 430 is between the first sub-gate electrode 440P1 and the second sub-gate electrode 440P2, the IC device 400 may have a dual-gate transistor structure. However, the inventive concept is not limited thereto. The second sub-gate electrode 440P2 may be omitted, and only the first sub-gate electrode 440P1 facing the first sidewall of the channel layer 430 may be formed to implement a single-gate transistor structure.

In some embodiments, similar to the word line WL described with reference to FIGS. 2A to 2D, the gate electrode 440 may include a work-function control conductive plug and a first conductive plug, which are sequentially stacked on the gate insulating layer 450, the work-function control conductive plug may include, for example, TiN including lanthanum (La) as a dopant, and the first conductive plug may include undoped TiN.

In some other embodiments, similar to the word line WL2A described with reference to FIG. 3, the gate electrode 440 may include a work-function control conductive plug, a first conductive plug, and a second conductive plug, which are sequentially stacked on the gate insulating layer 450, the work-function control conductive plug may include, for example, TiN including lanthanum (La) as a dopant, the first conductive plug may include , for example, undoped TiN, and the second conductive plug may include , for example, molybdenum (Mo).

In still some other embodiments, similar to the word line WL2B described with reference to FIG. 4, the gate electrode 440 may include a work-function control conductive plug, a first conductive plug, a second conductive plug, and a third conductive plug, which are sequentially stacked on the gate insulating layer 450, the work-function control conductive plug may include, for example, TiN including lanthanum (La) as a dopant, each of the first conductive plug and the third conductive plug may include, for example, undoped TiN, and the second conductive plug may include, for example, molybdenum (Mo).

In yet some other embodiments, similar to the word line WL3 described with reference to FIG. 5, the gate electrode 440 may include a work-function control conductive plug stacked on the gate insulating layer 450, and the work-function control conductive plug may include, for example, TiN including lanthanum (La) as a dopant.

The gate insulating layer 450 may surround a sidewall of the channel layer 430 and be between the channel layer 430 and the gate electrode 440. For example, as shown in FIG. 6B, the entire sidewall of the channel layer 430 may be surrounded by the gate insulating layer 450, and a portion of a sidewall of the gate electrode 440 may be in contact with the gate insulating layer 450. In some other embodiments, the gate insulating layer 450 may extend in the first lateral direction (e.g., X direction), which is a direction in which the gate electrode 440 extends longitudinally. From among sidewalls of the channel layer 430, only two sidewalls facing the gate electrode 440 may be in contact with the gate insulating layer 450.

In some embodiments, the gate insulating layer 450 may include, for example, a silicon oxide film, a silicon oxynitride film, a high-k dielectric film having a higher dielectric constant than the silicon oxide film, or a combination thereof. The high-k dielectric film may include, for example, a metal oxide or a metal oxynitride. For example, the high-k dielectric film that may be used as the gate insulating layer 450 may include HfO₂, HfSiO, HfSiON, HfTaO, HfTiO, HfZrO, ZrOz, Al₂O₃, or a combination thereof, without being limited thereto.

A plurality of second insulating patterns 432 may extend in the second lateral direction (e.g., Y direction) on the plurality of first insulating patterns 422, and the channel layer 430 may be between two adjacent ones of the plurality of second insulating patterns 432. In addition, between two adjacent second insulating patterns 432, a first buried layer 434 and a second buried layer 436 may be in a space between two adjacent channel layers 430. The first buried layer 434 may be in a bottom portion of a space between the two adjacent channel layers 430, and the second buried layer 436 may be formed to fill the remaining portion of the space between the two adj acent channel layers 430 on the first buried layer 434. A top surface of the second buried layer 436 may be at the same level as a top surface of the channel layer 430, and the second buried layer 436 may cover a top surface of the gate electrode 440. In some other embodiments, the plurality of second insulating patterns 432 may include a material layer that is continuous with the plurality of first insulating patterns 422. In some embodiments, the second buried layer 436 may include a material layer that is continuous with the first buried layer 434.

A capacitor contact 460 may be on the channel layer 430. The capacitor contact 460 may vertically overlap the channel layer 430. Capacitor contacts 460 may be arranged in a matrix form and be spaced apart from each other in the first lateral direction (e.g., X direction) and the second lateral direction (e.g., Y direction). The capacitor contact 460 may include, for example, doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrO, RuO, or a combination thereof, without being limited thereto. An upper insulating layer 462 may surround sidewalls of the capacitor contact 460 on the plurality of second insulating patterns 432 and the second buried layer 436.

An etching stop film 470 may be on the upper insulating layer 462, and a capacitor structure 480 may be on the etching stop film 470. The capacitor structure 480 may include a lower electrode 482, a capacitor dielectric layer 484, and an upper electrode 486.

The lower electrode 482 may pass through the etching stop film 470 and be electrically connected to a top surface of the capacitor contact 460. The lower electrode 482 may be formed as a pillar type extending in the vertical direction (e.g., Z direction), without being limited thereto. In some embodiments, the lower electrode 482 may vertically overlap the capacitor contact 460. Lower electrodes 482 may be arranged in a matrix form and be spaced apart from each other in the first lateral direction (e.g., X direction) and the second lateral direction (e.g., Y direction). In some other embodiments, a landing pad (not shown) may be further located between the capacitor contact 460 and the lower electrode 482, and thus, the lower electrode 482 may be arranged in a hexagonal shape.

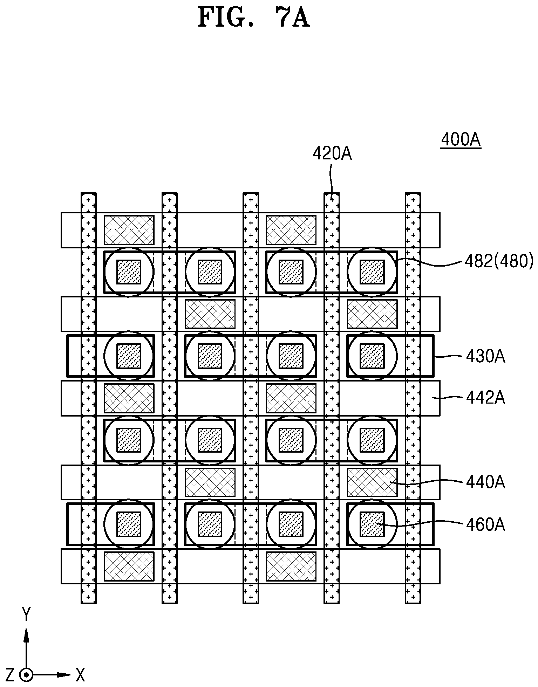

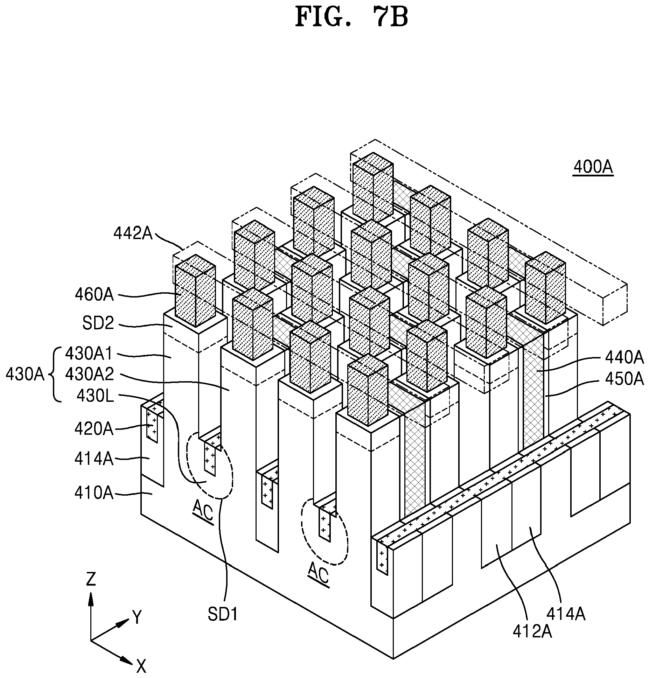

FIG. 7A is a layout diagram of an IC device 400A according to some embodiments of the present inventive concept, and FIG. 7B is a perspective view of the IC device 400A shown in FIG. 7A.

Referring to FIGS. 7A and 7B, the IC device 400A may include a substrate 410A, a plurality of first conductive lines 420A, a channel structure 430A, a contact gate electrode 440A, a plurality of second conductive lines 442A, and a capacitor structure 480. The IC device 400A may include a memory device including a VCT.

A plurality of active regions AC may be formed in the substrate 410A and defined by a first device isolation film 412A and a second device isolation film 414A. The channel structure 430A may be in each of the active regions AC. The channel structure 430A may include a first active pillar 430A1 and a second active pillar 430A2, which extend in a vertical direction, and a connection 430L, which is connected to the bottom of the first active pillar 430A1 and the bottom of the second active pillar 430A2. A first source/drain region SD1 may be in the connection 430L, a second source/drain region SD2 may be in an upper portion of each of the first and second active pillars 430A1 and 430A2. Each of the first active pillar 430A1 and the second active pillar 430A2 may constitute an independent unit memory cell.

The plurality of first conductive lines 420A may extend longitudinally in a direction intersecting with each of the plurality of active regions AC. For example, the plurality of first conductive lines 420A may extend longitudinally in a second lateral direction (e.g., Y direction). From among the plurality of first conductive lines 420A, one first conductive line 420A may be on the connection 430L between the first active pillar 430A1 and the second active pillar 430A2 and be located on the first source/drain region SD1. Another first conductive line 420A, which is adj acent to the one first conductive line 420A, may be between two channel structures 430A. From among the plurality of first conductive lines 420A, one first conductive line 420A may function as a common bit line included in two unit memory cells that include the first active pillar 430A1 and the second active pillar 430A2, which are on both sides of the one first conductive line 420A.

One contact gate electrode 440A may be between two channel structures 430A, which are adjacent to each other in the second lateral direction (e.g., Y direction). For instance, the contact gate electrode 440A may be between the first active pillar 430A1 of one channel structure 430A and the second active pillar 430A2 of another channel structure 430A adjacent thereto. One contact gate electrode 440A may be shared between the first active pillar 430A1 and the second active pillar 430A2 on both sidewalls thereof. A gate insulating layer 450A may be between the contact gate electrode 440A and the first active pillar 430A1 and between the contact gate electrode 440A and the second active pillar 430A2. The plurality of second conductive lines 442A may extend in a first lateral direction (e.g., X direction) on a top surface of the contact gate electrode 440A. Each of the plurality of second conductive lines 442A may function as a word line of the IC device 400A.

In some embodiments, similar to the word line WL described with reference to FIGS. 2A to 2D, the contact gate electrode 440A may include a work-function control conductive plug and a first conductive plug, which are sequentially stacked on the gate insulating layer 450A, the work-function control conductive plug may include, for example, TiN including lanthanum (La) as a dopant, and the first conductive plug may include undoped TiN.

In some other embodiments, similar to the word line WL2A described with reference to FIG. 3, the contact gate electrode 440A may include a work-function control conductive plug, a first conductive plug, and a second conductive plug, which are sequentially stacked on the gate insulating layer 450A, the work-function control conductive plug may include, for example, TiN including lanthanum (La) as a dopant, the first conductive plug may include, for example, undoped TiN, and the second conductive plug may include, for example, molybdenum (Mo).

In still some other embodiments, similar to the word line WL2B described with reference to FIG. 4, the contact gate electrode 440A may include a work-function control conductive plug, a first conductive plug, a second conductive plug, and a third conductive plug, which are sequentially stacked on the gate insulating layer 450A, the work-function control conductive plug may include, for example, TiN including lanthanum (La) as a dopant, each of the first conductive plug and the third conductive plug may include, for example, undoped TiN, and the second conductive plug may include, for example, molybdenum (Mo).

In yet some other embodiments, similar to the word line WL3 described with reference to FIG. 5, the contact gate electrode 440A may include a work-function control conductive plug stacked on the gate insulating layer 450A, and the work-function control conductive plug may include, for example, TiN including lanthanum (La) as a dopant.

A capacitor contact 460A may be on the channel structure 430A. The capacitor contact 460A may be on the second source/drain region SD2, and the capacitor structure 480 may be on the capacitor contact 460A.

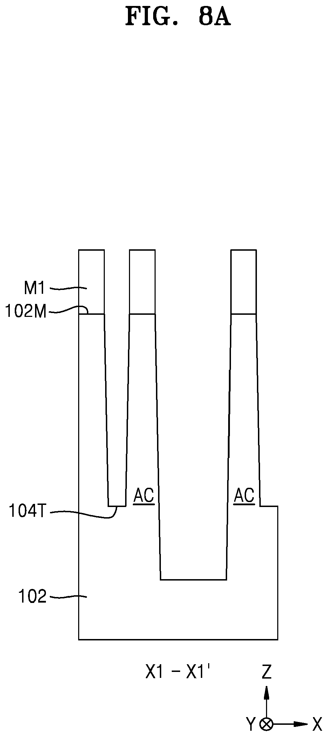

FIGS. 8A through 16B are cross-sectional views illustrating a method of manufacturing an IC device, according to some embodiments of the present inventive concept. In some embodiments, processes may be sequentially performed as illustrated in FIGS. 8A through 16B. FIGS. 8A, 9A, 10A, 11A, 12A, 13A, 14A, 15A and 16A are cross-sectional views taken along line X1 - X1' of FIG. 1, and FIGS. 8B, 9B, 10B, 11B, 12B, 13B, 14B, 15B and 16B are cross-sectional views taken along line Y1 - Y1' of FIG. 1. An example method of manufacturing the IC device 100 shown in FIGS. 1 and 2A to 2D is described with reference to FIGS. 8A to 16B.

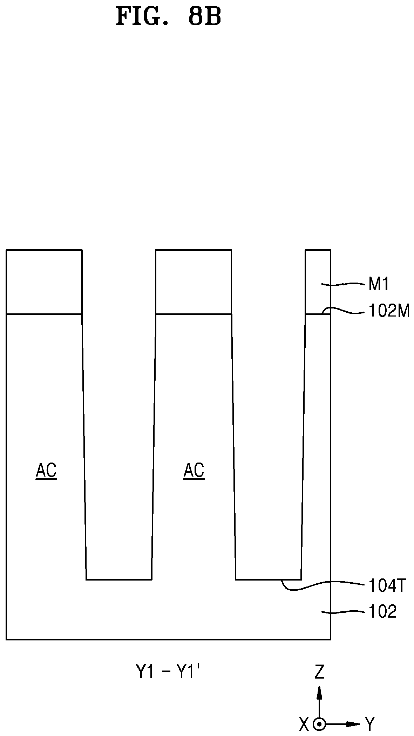

Referring to FIGS. 8A and 8B, a mask pattern M1 may be formed on a main surface 102M of a substrate 102, and the substrate 102 may be etched by using the mask pattern M1 as an etch mask, and thus, a device isolation trench 104T may be formed in the substrate 102. A plurality of active regions AC may be defined by the device isolation trench 104T in the substrate 102. The mask pattern M1 may include, for example, a hard mask including an oxide film, polysilicon, or a combination thereof.

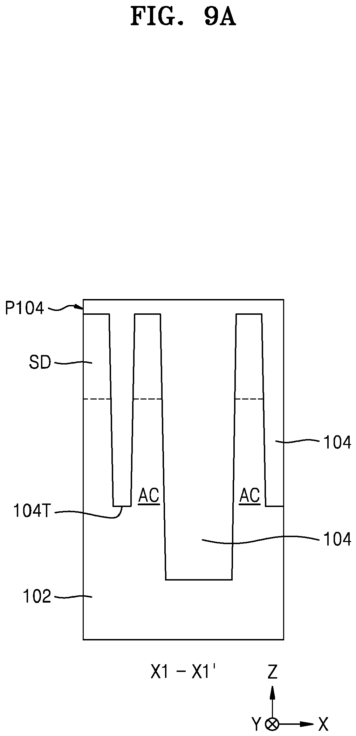

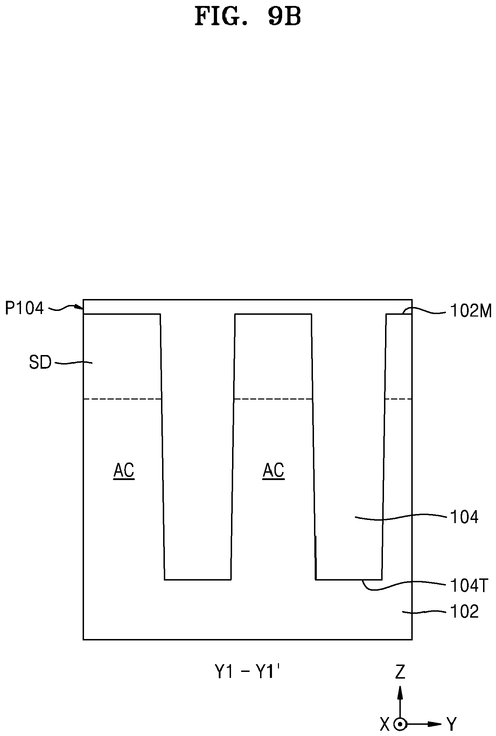

Referring to FIGS. 9A and 9B, the mask pattern M1 may be removed from the resultant structure of FIGS. 8A and 8B. Thereafter, an insulating film P104 may be formed to fill the device isolation trench 104T and cover a main surface 102M of the substrate 102, and an ion implantation process for forming a plurality of source/drain regions SD in the substrate 102 may be performed. A portion of the insulating film P104, which fills the device isolation trench 104T, may serve as a device isolation film 104. A portion of the insulating film P104, which covers the main surface 102M of the substrate 102, may protect the main surface 102M of the substrate 102 during the ion implantation process for forming the plurality of source/drain regions SD or subsequent processes (e.g., an etching process).

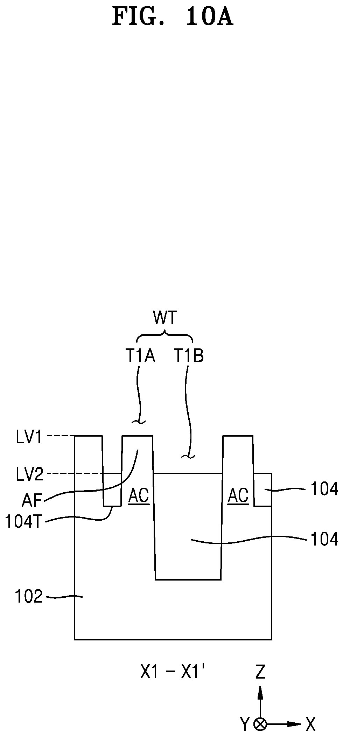

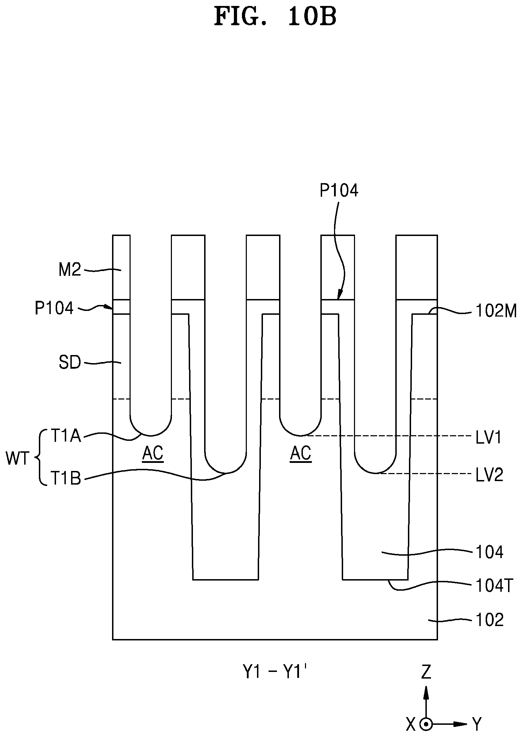

Referring to FIGS. 10A and 10B, a mask pattern M2 may be formed on the resultant structure of FIGS. 9A and 9B, and a portion of the insulating film P104 and a portion of the substrate 102 may be etched by using the mask pattern M2 as an etch mask. Thus, a plurality of word line trenches WT extending longitudinally in a first lateral direction (e.g., X direction) may be formed to intersect with the plurality of active regions AC and the device isolation film 104. Each of the plurality of word line trenches WT may include a first trench portion T1A and a second trench portion T1B. The first trench portion T1A may have a bottom surface exposing the substrate 102 at a first vertical level LV1. The second trench portion T1B may have a bottom surface exposing the device isolation film 104 at a second vertical level LV2. Here, the second vertical level LV2 may be lower than the first vertical level LV1. The mask pattern M2 may include, for example, an oxide film, an amorphous carbon layer (ACL), a silicon oxynitride (SiON) film, or a combination thereof.

To form the plurality of word line trenches WT, a first etching process and a second etching process may be sequentially performed on the main surface 102M of the substrate 102. The first etching process may include etching the substrate 102 and the device isolation film 104 under a condition that the substrate 102 and the device isolation film 104 are etched at substantially the same etch rate. The second etching process may include etching the substrate 102 and the device isolation film 104 under a condition that an etch rate of the device isolation film 104 is etched at a higher etch rate than the substrate 102. As a result, the second vertical level LV2 of the bottom surface of the second trench portion T1B exposing the device isolation film 104 may be lower than first vertical level LV1 of the bottom surface of the first trench portion T1A exposing the substrate 102. The first trench portion T1A and the second trench portion T1B may have substantially the same width or substantially similar widths in the second lateral direction (e.g., Y direction).

The plurality of active regions AC may include a plurality of fin areas AF, which protrude upward in the vertical direction (e.g., Z direction) from the second vertical level LV2 to the first vertical level LV1 inside the plurality of word line trenches WT, respectively.

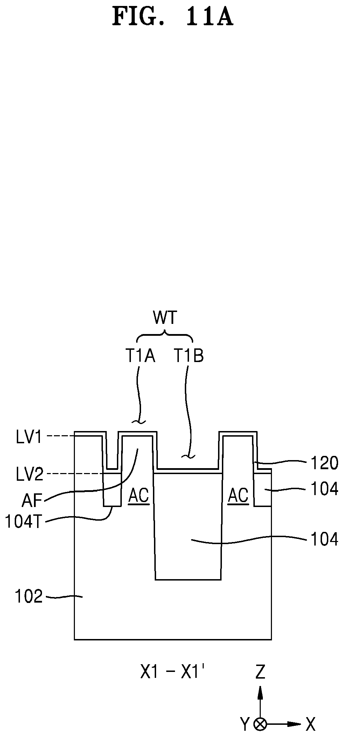

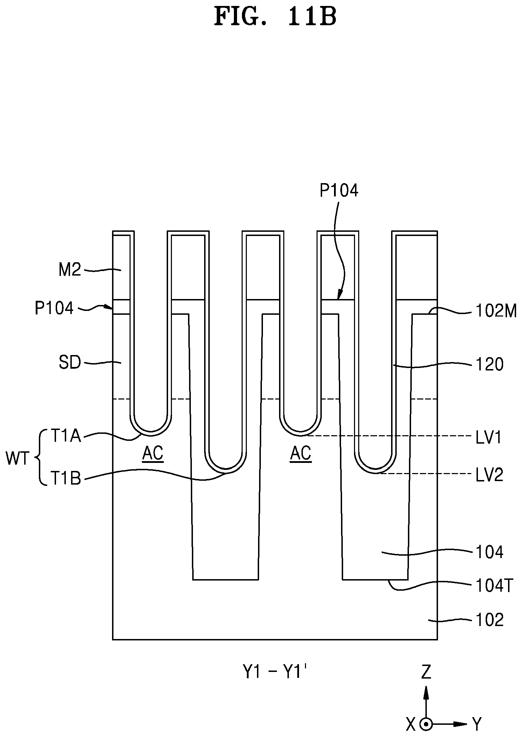

Referring to FIGS. 11A and 11B, a gate dielectric film 120 may be formed on the resultant structure of FIGS. 10A and 10B. The gate dielectric film 120 may be formed to conformally cover an inner wall of each of the plurality of word line trenches WT. The gate dielectric film 120 may include, for example, a silicon oxide film.

The gate dielectric film 120 may be formed by using, for example, an atomic layer deposition (ALD) process. In some embodiments, the process of forming the gate dielectric film 120 may be performed in a plasma atmosphere by using O₂ gas and inert gas. In some other embodiments, the process of forming the gate dielectric film 120 may be performed in a plasma atmosphere by using O₂ gas, inert gas, and H₂ gas. In still some other embodiments, during the formation of the gate dielectric film 120, an in-situ steam generation (ISSG) process using vapor or a combination of H₂ gas and O₂ gas may be performed.

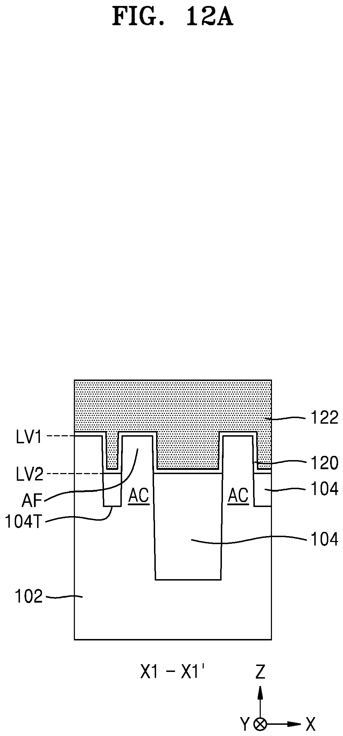

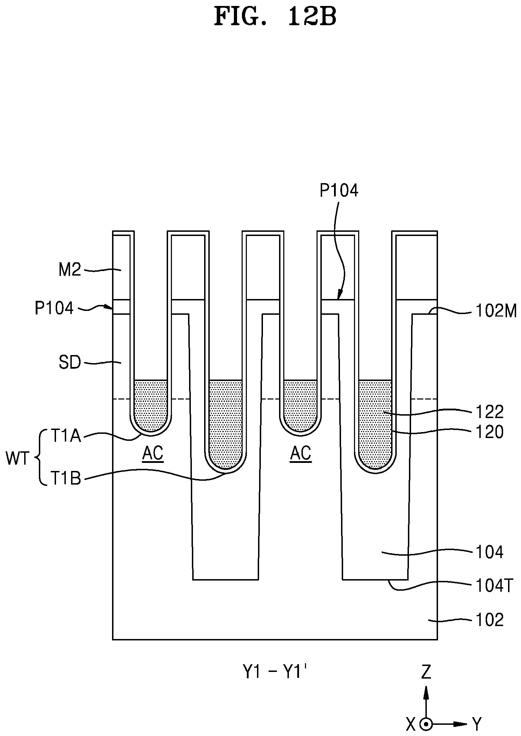

Referring to FIGS. 12A and 12B, a plurality of conductive metal nitride films 122 may be formed on the gate dielectric film 120 to fill portions (e.g., lower spaces) of the plurality of word line trenches WT, respectively. The plurality of conductive metal nitride films 122 may include, for example, TiN.

In some embodiments, to form the plurality of conductive metal nitride films 122, a conductive metal nitride may be deposited to such a sufficient thickness as to fill the plurality of word line trenches WT on the resultant structure of FIGS. 11A and 11B. Thereafter, a portion of the conductive metal nitride may be etched back, and thus, the conductive metal nitride film 122 may be left in the lower space of each of the plurality of word line trenches WT. After the plurality of conductive metal nitride films 122 are formed, an upper space of each of the plurality of word line trenches WT may be emptied.

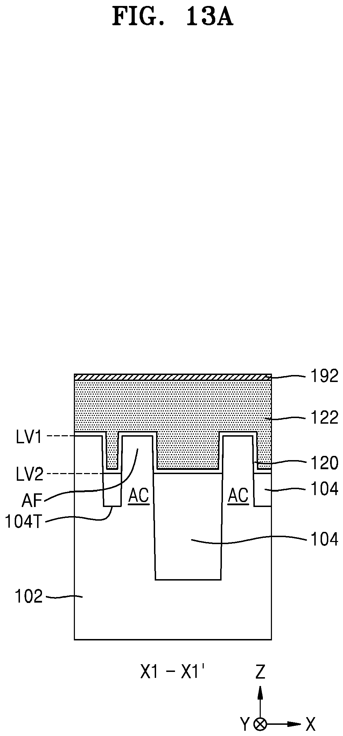

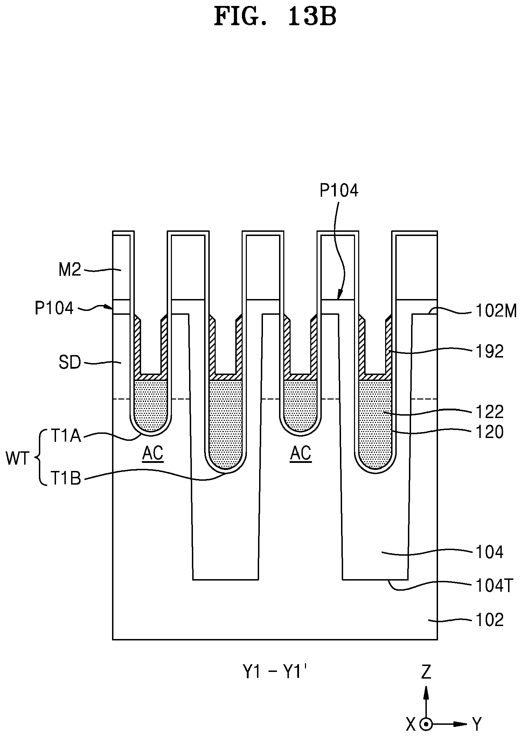

Referring to FIGS. 13A and 13B, a protective liner 192 may be formed to cover the gate dielectric film 120, which is exposed on the conductive metal nitride film 122 inside each of the plurality of word line trenches WT.

The protective liner 192 may be formed to conformally cover not only a surface of the gate dielectric film 120 but also a top surface of the conductive metal nitride film 122. The protective liner 192 may protect the gate dielectric film 120 from being damaged during a subsequent process of forming a work-function control conductive plug 122B. In some embodiments, the protective liner 192 may include, for example, a TiN film, a silicon oxide film, a silicon nitride film, or a combination thereof.

In some embodiments, to form the protective liner 192, a protective film may be formed to conformally cover exposed surfaces in the resultant structure of FIGS. 12A and 12B. Thereafter, a portion of the protective film may be removed, and thus, the protective liner 192 may remain inside each of the plurality of word line trenches WT. After the protective liner 192 is formed, a space may remain on the protective liner 192 inside each of the plurality of word line trenches WT.

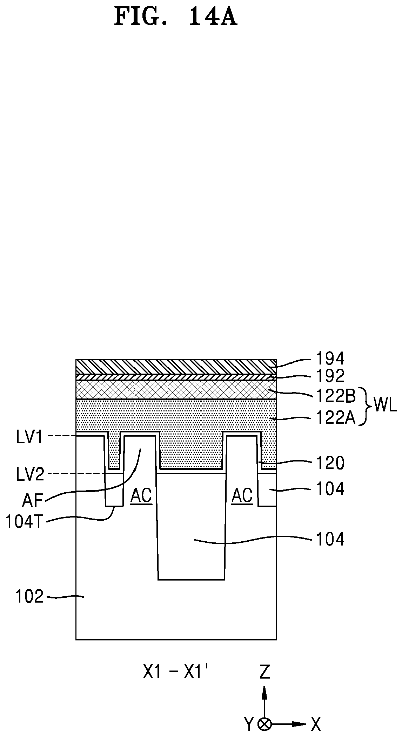

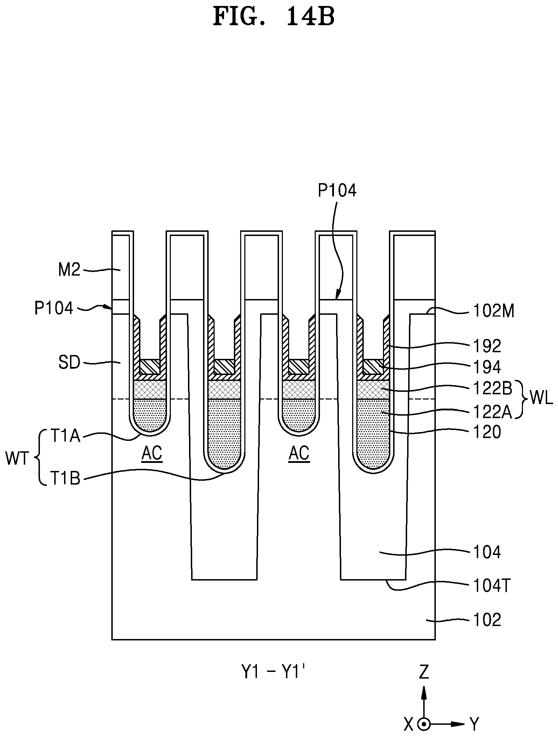

Referring to FIGS. 14A and 14B, while the gate dielectric film 120 is being covered by the protective liner 192 on the conductive metal nitride film 122, a metal oxide film 194 may be formed on the protective liner 192.

To form the metal oxide film 194, a metal oxide may be blanket-deposited on the resultant structure of FIGS. 13A and 13B. Thereafter, a portion of the metal oxide may be removed, and thus, the metal oxide film 194 may remain over the conductive metal nitride film 122 inside each of the plurality of word line trenches WT. The metal oxide film 194 may be spaced apart from each the conductive metal nitride film 122 and the gate dielectric film 120 with the protective liner 192 therebetween. The metal oxide film 194 may include, for example, a lanthanum oxide film.

Thereafter, the resultant structure including the metal oxide film 194 may be annealed, and thus, metal atoms may diffuse from the metal oxide film 194 into the conductive metal nitride film 122. As a result, an upper portion of the conductive metal nitride film 122 may be converted into a work-function control conductive plug 122B. The work-function control conductive plug 122B may include a conductive metal nitride including a metal dopant. For example, the work-function control conductive plug 122B may include TiN including lanthanum (La) as a dopant. After the work-function control conductive plug 122B is formed, the remaining portion of the conductive metal nitride film 122 may be left as a first conductive plug 122A. The first conductive plug 122A may include, for example, undoped TiN.

The annealing process may be performed at a temperature of, for example, about 400 °C to about 950 °C, without being limited thereto. In some other embodiments, the annealing process may be omitted. In this case, metal atoms may diffuse from the metal oxide film 194 into the conductive metal nitride film 122 due to a process atmosphere during or after the formation of the metal oxide film 194 without an additional annealing process, and thus, the work-function control conductive plug 122B may be obtained. Because the gate dielectric film 120 is covered by the protective liner 192 on the conductive metal nitride film 122, there may be no concern that the gate dielectric film 120 is adversely affected by metal atoms diffused from the metal oxide film 194 during the formation of the work-function control conductive plug 122B.

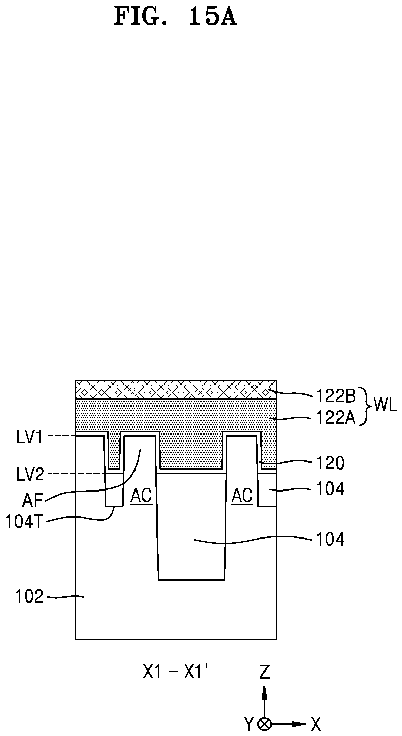

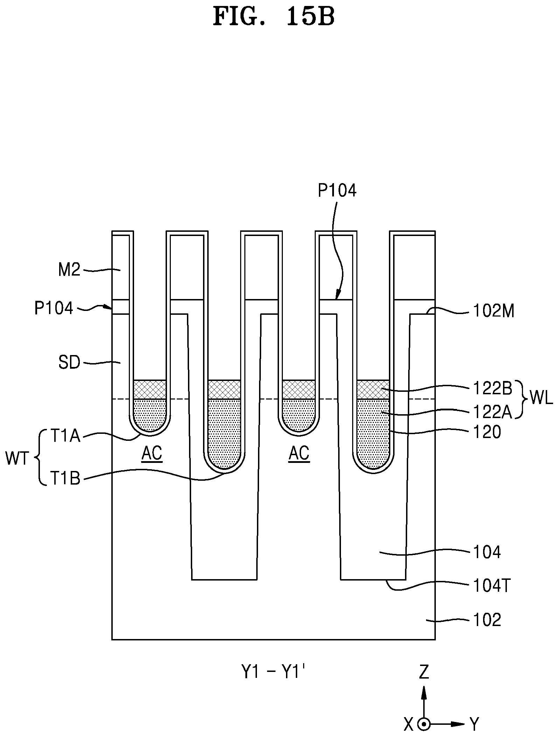

Referring to FIGS. 15A and 15B, the metal oxide film 194 and the protective liner 192 may be removed from the resultant structure of FIGS. 14A and 14B in which the work-function control conductive plug 122B is formed, and thus, a top surface of the work-function control conductive plug 122B and the gate dielectric film 120 may be exposed.

In some embodiments, the metal oxide film 194 and the protective liner 192 may be completely removed from the resultant structure of FIGS. 14A and 14B. As a result, inside the word line trench WT, the entire region of the top surface of the work-function control conductive plug 122B and the surface of the gate dielectric film 120 at a higher vertical level than the top surface of the work-function control conductive plug 122B is exposed, and residue of the protective liner 192 may not remain on each of the top surface of the work-function control conductive plug 122B and the surface of the gate dielectric film 120.

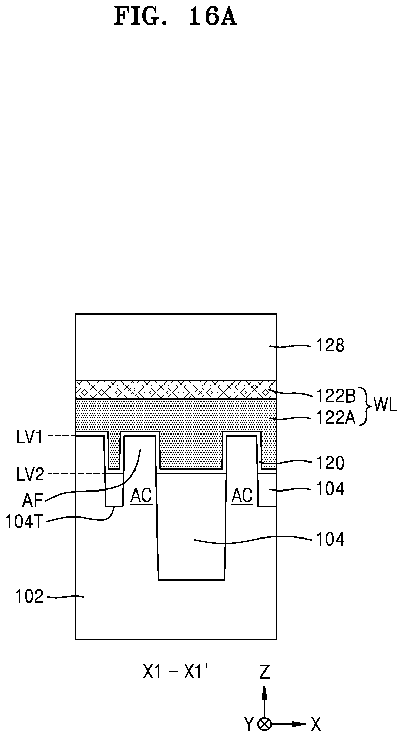

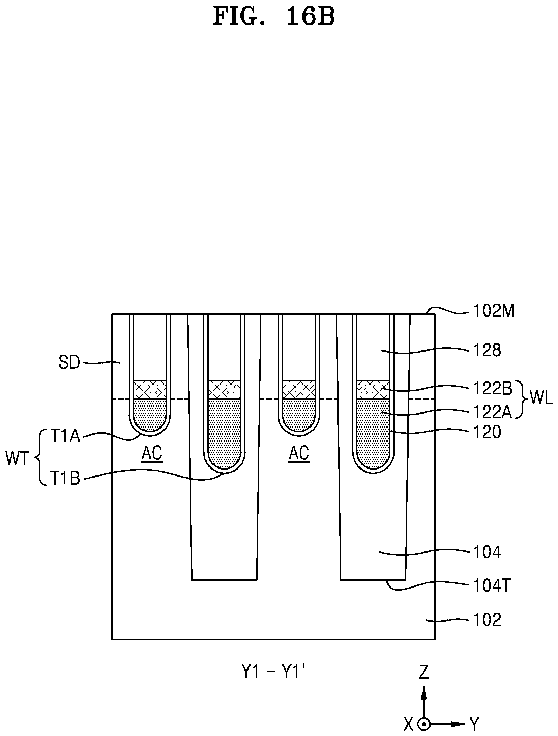

In some other embodiments, differently from that illustrated in FIGS. 15A and 15B, although the metal oxide film 194 is completely removed from the resultant structure of FIGS. 14A and 14B, a portion of the protective liner 192 may remain. In this case, the residue of the protective liner 192 remaining on at least one of the top surface of the work-function control conductive plug 122B and the surface of the gate dielectric film 120 may constitute a portion of an insulating capping pattern (refer to 128 in FIGS. 16A and 16B) that is formed in a subsequent process.

Referring to FIGS. 16A and 16B, in the resultant structure of FIGS. 15A and 15B, the insulating capping pattern 128 may be formed to fill the upper space of each of the plurality of word line trenches WT. Thereafter, films formed on the substrate 102 may be removed to expose the main surface 102M of the substrate 102.

In some embodiments, to form the insulating capping pattern 128, the upper space of each of the plurality of word line trenches WT may be filled by a silicon nitride film. As in the resultant structure of FIGS. 15A and 15B, when the metal oxide film 194 and the protective liner 192 are completely removed and the residue of the protective liner 192 does not remain on each of the top surface of the work-function control conductive plug 122B and the surface of the gate dielectric film 120, the insulating capping pattern 128 may include, for example, a silicon nitride film.

In some other embodiments, differently from those illustrated in FIGS. 15A and 15B, after the processes described with reference to FIGS. 15A and 15B are performed, when the residue of the protective liner 192 remains on at least one of the top surface of the work-function control conductive plug 122B and the surface of the gate dielectric film 120 inside the word line trench WT, the upper space of each of the plurality of word line trenches WT may be filled by a silicon nitride film to form the insulating capping pattern 128. Thus, the insulating capping pattern 128 including the residue of the protective liner 192 and the silicon nitride film may be obtained. When the protective liner 192 includes a silicon oxide film, the insulating capping pattern 128 may include a silicon oxide film and a silicon nitride film. The silicon oxide film may cover at least a portion of the top surface of the work-function control conductive plug 122B and the surface of the gate dielectric film 120. The silicon nitride film may fill the upper space of the word line trench WT on the silicon oxide film.

Although the processes described with reference to FIGS. 12A to 16B pertain to a case in which a process of forming a plurality of word lines WL is performed in a state in which the mask pattern M2 remains on the substrate 102, when necessary, a subsequent process may be performed after the mask pattern M2 is removed in any one of the processes described with reference to FIGS. 12A to 16B.

Afterwards, a buffer insulating film 130, a plurality of direct contacts DC, a plurality of bit lines BL, a plurality of insulating spacers 146, an insulating fence 142, a plurality of conductive plugs 140P, a metal silicide film 172, a conductive landing pad LP, and an insulating film 180 may be formed on the substrate 102, and thus, the IC device 100 having the configuration shown in FIGS. 2A to 2D may be manufactured.

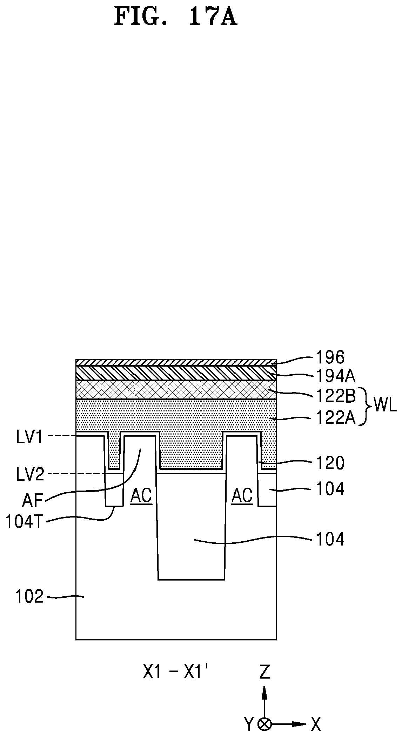

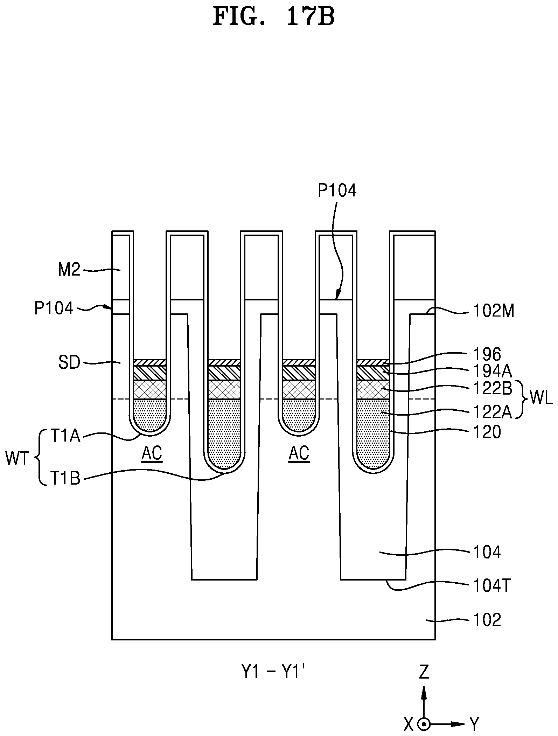

FIGS. 17A and 17B are cross-sectional views illustrating a method of manufacturing an IC device according to some embodiments of the present inventive concept. FIG. 17A illustrates a cross-sectional configuration of portions corresponding to a cross-section taken along line X1-X1' of FIG. 1. FIG. 17B illustrates a cross-sectional configuration of portions corresponding to a cross-section taken along line Y1-Y1' of FIG. 1. Another example method of manufacturing the IC device 100 shown in FIGS. 1 and 2A to 2D is described with reference to FIGS. 17A and 17B.

Referring to FIGS. 17A and 17B, the processes described with reference to FIGS. 8A to 12B may be performed. Thereafter, a metal oxide film 194A covering a top surface of a conductive metal nitride film 122 may be formed inside each of the plurality of word line trenches WT. To form the metal oxide film 194A, a metal oxide may be blanket-deposited on the resultant structure of FIGS. 13A and 13B. Thereafter, a portion of the metal oxide may be removed, and thus, the metal oxide film 194A may remain over the conductive metal nitride film 122 inside each of the plurality of word line trenches WT. The metal oxide film 194A may be formed to contact the top surface of the conductive metal nitride film 122. The metal oxide film 194A may include a lanthanum oxide film.

Afterwards, a protective liner 196 may be formed to cover a top surface of the metal oxide film 194A. The protective liner 196 may include, for example, TiN, a silicon oxide film, a silicon nitride film, or a combination thereof.

In some embodiments, to form the protective liner 196, a protective film may be formed to conformally cover exposed surfaces in the resultant structure including the metal oxide film 194A. Thereafter, a portion of the protective film may be removed, and thus, the protective liner 196 may remain inside each of the plurality of word line trenches WT. After the protective liner 196 is formed, a space may remain on the protective liner 196 inside each of the plurality of word line trenches WT. The protective liner 196 may reduce or prevent outgassing of conductive elements included in the work-function control conductive plug 122B after a work-function control conductive plug 122B is formed in a subsequent process.

The resultant structure including the protective liner 196 may be annealed in a similar manner to that described with reference to FIGS. 14A and 14B, and thus, metal atoms may diffuse from the metal oxide film 194A into the conductive metal nitride film 122. As a result, the work-function control conductive plug 122B may be obtained from an upper portion of the conductive metal nitride film 122. After the work-function control conductive plug 122B is formed, the remaining portion of the conductive metal nitride film 122 may be left as the first conductive plug 122A. The annealing process may be omitted. In this case, metal atoms may diffuse from the metal oxide film 194A into the conductive metal nitride film 122 due to a process atmosphere during or after the formation of the metal oxide film 194A and the protective liner 196 without an additional annealing process, and thus, the work-function control conductive plug 122B may be obtained.

Thereafter, the metal oxide film 194A and the protective liner 196 remaining on the resultant structure including the work-function control conductive plug 122B may be removed in a similar manner to that described with reference to FIGS. 15A and 15B, and the processes described with reference to FIGS. 16A and 16B may be performed. Thus, the IC device 100 having the configuration illustrated in FIGS. 2A to 2D may be manufactured.

The processes described with reference to FIGS. 8A to 12B may be performed to manufacture the IC device 200A described with reference to FIG. 3. However, before the process of forming the plurality of conductive metal nitride films 122 is performed in the processes described with reference to FIGS. 12A and 12B, a second conductive plug 234 may be formed on a portion of the gate dielectric film 120, which is adjacent to a bottom surface of each of the plurality of word line trenches WT. The second conductive plug 234 may include a single metal. In some embodiments, the second conductive plug 234 may include, for example, molybdenum (Mo).

In some embodiments, to form the second conductive plug 234, a Mo film may be formed on the gate dielectric film 120 in the resultant structure of FIGS. 11A and 11B, and a portion of the Mo film may be removed. Thus, the second conductive plug 234 may remain on the portion of the gate dielectric film 120, which is adjacent to the bottom surface of the word line trench WT.

Thereafter, processes similar to those described with reference to FIGS. 13A to 16B or processes similar to those described with reference to FIGS. 17A and 17B may be performed on the resultant structure including the second conductive plug 234, and thus, the IC device 200A shown in FIG. 3 may be manufactured.

The processes described with reference to FIGS. 8A to 16B may be performed to manufacture the IC device 200B described with reference to FIG. 4. However, before the process of forming the plurality of conductive metal nitride films 122 is performed in the process described with reference to FIGS. 12A and 12B, a third conductive plug 236 and a second conductive plug 234B may be sequentially formed on a portion of the gate dielectric film 120, which is adjacent to the bottom surface of each of the plurality of word line trenches WT. The third conductive plug 236 may include, for example, an undoped conductive metal nitride, and the second conductive plug 234B may include a single metal. For example, the third conductive plug 236 may include, for example, undoped TiN, and the second conductive plug 234B may include, for example, molybdenum (Mo).

In some embodiments, to form the third conductive plug 236, a TiN film may be formed on the gate dielectric film 120 in the resultant structure of FIGS. 11A and 11B, and a portion of the TiN film may be removed. Thus, the third conductive plug 236 may remain on the portion of the gate dielectric film 120, which is adjacent to the word line trench WT.

In some embodiments, to form the second conductive plug 234B, a Mo film may be formed on the resultant structure including the third conductive plug 236, and a portion of the Mo film may be removed. Thus, the second conductive plug 234B may remain on the third conductive plug 236 inside the word line trench WT.

Thereafter, processes similar to those described with reference to FIGS. 13A to 16B or processes similar to those described with reference to FIGS. 17A and 17B may be performed on the resultant structure including the second conductive plug 234B, and thus, the IC device 200B shown in FIG. 4 may be manufactured.

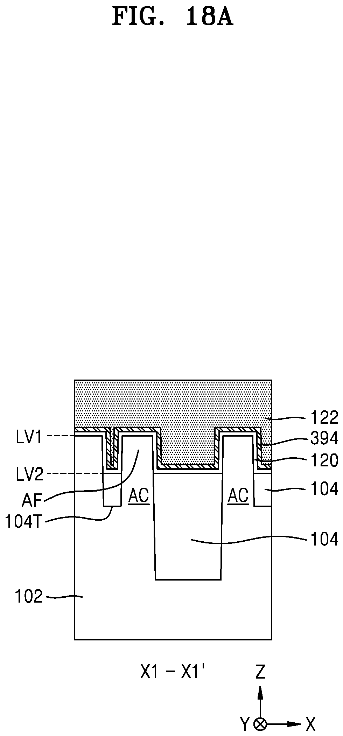

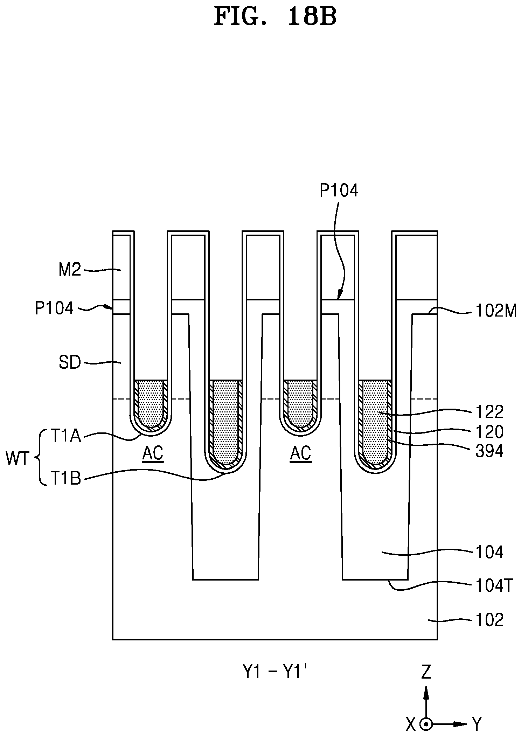

FIGS. 18A and 18B are cross-sectional views illustrating a method of manufacturing an IC device, according to some embodiments of the present inventive concept. FIG. 18A illustrates a cross-sectional configuration of portions corresponding to a cross-section taken along line X1-X1' of FIG. 1. FIG. 18B illustrates a cross-sectional configuration of portions corresponding to a cross-section taken along line Y1-Y1' of FIG. 1. An example method of manufacturing the IC device 300 shown in FIG. 5 is described with reference to FIGS. 18A and 18B.

Referring to FIGS. 18A and 18B, processes up to forming a gate dielectric film 120 may be performed as described with reference to FIGS. 8A to 11B. Thereafter, as described with reference to FIGS. 12A and 12B, a process of forming a plurality of conductive metal nitride films 122 may be performed. However, in the present embodiment, a metal oxide film 394 may be further formed between the gate dielectric film 120 and the conductive metal nitride film 122 inside each of the plurality of word line trenches WT. In some embodiments, the metal oxide film 394 may include, for example, a lanthanum oxide film.

As shown in FIGS. 18A and 18B, to form a structure in which the metal oxide film 394 and the conductive metal nitride film 122 are sequentially stacked on the gate dielectric film 120 inside each of the plurality of word line trenches WT, initially, a lanthanum oxide film may be formed by using, for example, an ALD process to conformally cover exposed surfaces in the resultant structure of FIGS. 11A and 11B. Next, a TiN film may be formed to fill remaining spaces on the lanthanum oxide film inside the plurality of word line trenches WT. Thereafter, a portion of each of the TiN film and the lanthanum oxide film may be removed to obtain the resultant structure shown in FIGS. 18A and 18B.

Afterwards, the obtained resultant structure may be annealed in a similar manner to that described with reference to FIGS. 14A and 14B, and thus, metal atoms may diffuse from the metal oxide film 394 into the conductive metal nitride film 122. As a result, as shown in FIG. 5, the work-function control conductive plug 322 including a conductive metal nitride including a metal dopant as a dopant may be obtained from the conductive metal nitride film 122.

After the metal atoms diffuse from the metal oxide film 394 into the conductive metal nitride film 122, oxygen atoms remaining in the metal oxide film 394 may be converted into a form of an oxide (e.g., titanium oxide, lanthanum oxide, and/or silicon oxide). Portions of the gate dielectric film 120 in contact with the metal oxide film 394 may increase in thickness due to the oxide. As a result, a gate dielectric film 320 including a first portion 320A having a relatively thick thickness may be obtained as described above with reference to FIG. 5. A portion of the gate dielectric film 120 at a higher vertical level than the metal oxide film 394 may be maintained at a relatively thin original thickness. The portion of the gate dielectric film 120 may remain as the second portion 320B of the gate dielectric film 320 shown in FIG. 5.

As shown in FIGS. 18A and 18B, the above-described embodiment pertains to an example in which the structure in which the metal oxide film 394 and the conductive metal nitride film 122 are sequentially stacked on the gate dielectric film 120 inside each of the plurality of word line trenches WT may be first formed, and the metal atoms may diffuse from the metal oxide film 394 into the conductive metal nitride film 122 by using an annealing process, but the inventive concept is not limited thereto. For example, the annealing process may be omitted, and metal atoms may diffuse from the metal oxide film 394 into the conductive metal nitride film 122 during the formation of the metal oxide film 394 and the conductive metal nitride film 122.

In some other embodiments, differently from that described above, a lanthanum oxide film may be formed to conformally cover exposed surfaces in the resultant structure of FIGS. 11A and 11B, and a TiN film may be formed to fill remaining spaces of the plurality of word line trenches WT on the lanthanum oxide film. Thereafter, an annealing process may be performed as needed, and thus, metal atoms may diffuse from the metal oxide film 394 into the conductive metal nitride film 122. Subsequently, a portion of the obtained resultant structure may be removed to form the work-function control conductive plug 322 shown in FIG. 5. In this case, a gate dielectric film having a substantially constant width in the second lateral direction (e.g., Y direction) may be obtained in the vertical direction (e.g., Z direction) instead of the gate dielectric film 320 shown in FIG. 5.

Although example methods of manufacturing the IC devices 100, 200A, 200B, and 300 shown in FIGS. 1 to 5 have been described with reference to FIGS. 8A to 18B, the inventive concept is not limited thereto. It will be understood that IC devices having various structures may be manufactured by applying various modifications and changes to the IC devices 100, 200A, 200B, and 300 shown in FIGS. 1 to 5 within the scope of the inventive concept.

As used herein, an element or region that is "covering" or "surrounding" or "filling" another element or region may completely or partially cover or surround or fill the other element or region.

Although terms (e.g., first, second or third) may be used herein to describe various elements, these elements should not be limited by these terms. These terms are only used to distinguish one element from another. For example, a first element may be referred to as a second element, and, similarly a second element may be referred to as a first element without departing from the teachings of the disclosure.

While the inventive concept has been shown and described with reference to example embodiments thereof, it will be understood that various changes in form and details may be made therein without departing from the scope of the following claims. The above-disclosed subject matter is to be considered illustrative, and not restrictive, and the appended claims are intended to cover all such modifications, enhancements, and other embodiments, which fall within the scope of the present inventive concept. Thus, to the maximum extent allowed by law, the scope is to be determined by the broadest permissible interpretation of the following claims, and shall not be restricted or limited by the foregoing detailed description.

## Claims

1. An integrated circuit device comprising:
a substrate;
a word line that is in the substrate and extends longitudinally in a first horizontal direction;
a gate dielectric film extending between the substrate and the word line; and
an insulating capping pattern that is in the substrate and on the word line, the insulating capping pattern extending longitudinally in the first horizontal direction,
wherein the word line comprises a work-function control conductive plug that comprises a conductive metal nitride comprising a metal dopant, and
the work-function control conductive plug comprises a top surface in contact with a bottom surface of the insulating capping pattern, a sidewall in contact with the gate dielectric film and a bottom surface in contact with a monolithic layer.

2. The integrated circuit device of claim 1, wherein the word line further comprises a first conductive plug that is spaced apart from the insulating capping pattern in a vertical direction with the work-function control conductive plug therebetween,
the first conductive plug comprises an undoped conductive metal nitride, and the first conductive plug comprises a top surface in contact with the bottom surface of the work-function control conductive plug and a sidewall in contact with the gate dielectric film, and
a work function of the work-function control conductive plug is smaller than a work function of the first conductive plug.

3. The integrated circuit device of claim 1, wherein the word line further comprises a first conductive plug that comprises a top surface in contact with the bottom surface of the work-function control conductive plug,
the sidewall of the work-function control conductive plug and a sidewall of the first conductive plug are on the same plane without a step adjacent to an interface between the work-function control conductive plug and the first conductive plug,
the work-function control conductive plug comprises TiN that comprises lanthanum, La, as a dopant, and
the first conductive plug comprises undoped TiN.

4. The integrated circuit device of claim 1, wherein the word line further comprises a first conductive plug that comprises a first top surface in contact with the bottom surface of the work-function control conductive plug, and
the first conductive plug further comprises first surfaces that are different from the first top surface and are in contact with the gate dielectric film.

5. The integrated circuit device of claim 1, wherein the substrate comprises a plurality of active regions defined by a device isolation film,
the word line and the insulating capping pattern each have a line shape and intersect with the plurality of active regions and the device isolation film,
the word line further comprises a first conductive plug that is enclosed by the work-function control conductive plug and the gate dielectric film, and
the first conductive plug comprises a portion that vertically overlaps one of the plurality of active regions and has a first length in a vertical direction and a portion that vertically overlaps the device isolation film and has a second length in the vertical direction, and the first length is shorter than the second length.

6. The integrated circuit device of claim 1, wherein the word line further comprises:
a first conductive plug that is spaced apart from the insulating capping pattern in a vertical direction with the work-function control conductive plug therebetween, the first conductive plug comprising a first top surface in contact with the bottom surface of the work-function control conductive plug and a first sidewall in contact with the gate dielectric film, the first conductive plug comprising a first undoped conductive metal nitride; and
a second conductive plug that is spaced apart from the insulating capping pattern in the vertical direction with the work-function control conductive plug and the first conductive plug therebetween, the second conductive plug comprising a second top surface in contact with a bottom surface of the first conductive plug and a second sidewall in contact with the gate dielectric film, and the second conductive plug comprising a monolithic metal layer.

7. The integrated circuit device of claim 6, wherein the sidewall of the work-function control conductive plug, the first sidewall of the first conductive plug, and the second sidewall of the second conductive plug are on the same plane without a step adjacent to an interface between the work-function control conductive plug and the first conductive plug and adjacent to an interface between the first conductive plug and the second conductive plug, and
the work-function control conductive plug, the first conductive plug, and the second conductive plug are spaced apart from a main surface of the substrate by respectively different vertical distances.

8. The integrated circuit device of claim 6 or 7, wherein the work-function control conductive plug comprises TiN that comprises lanthanum (La) as a dopant,
the first conductive plug comprises undoped TiN, and
the second conductive plug comprises molybdenum (Mo).

9. The integrated circuit device of claim 6, 7 or 8, wherein the second conductive plug further comprises second surfaces that are different from the second top surface and are in contact with the gate dielectric film.

10. The integrated circuit device of any one of claims 6 to 9, wherein the word line further comprises a third conductive plug that is spaced apart from the first conductive plug in the vertical direction with the second conductive plug therebetween, the third conductive plug comprising a third top surface in contact with a bottom surface of the second conductive plug and comprising a second undoped conductive metal nitride, and
the third conductive plug further comprises third surfaces that are different from the third top surface and are in contact with the gate dielectric film.

11. The integrated circuit device of claim 1, wherein the word line further comprises a first conductive plug, a second conductive plug, and a third conductive plug, each of which is spaced apart from the insulating capping pattern in a vertical direction with the work-function control conductive plug therebetween, the first conductive plug, the second conductive plug, and the third conductive plug are spaced apart from the insulating capping pattern by respectively different vertical distances,
the first conductive plug and the third conductive plug are spaced apart from each other in the vertical direction with the second conductive plug therebetween and each comprise an undoped conductive metal nitride, and
the second conductive plug comprises a monolithic metal layer.

12. The integrated circuit device of claim 11, wherein the work-function control conductive plug comprises TiN that comprises lanthanum (La) as a dopant,
each of the first conductive plug and the third conductive plug comprises undoped TiN, and
the second conductive plug comprises molybdenum (Mo).

13. The integrated circuit device of claim 1, wherein the word line consists of the work-function control conductive plug,
the gate dielectric film comprises a first portion in contact with the work-function control conductive plug and a second portion in contact with the insulating capping pattern, and
a thickness of the first portion of the insulating capping pattern is greater than a thickness of the second portion of the insulating capping pattern in a second horizontal direction that is perpendicular to the first horizontal direction.

14. An integrated circuit device comprising:
a substrate comprising a plurality of active regions and a word line trench, the plurality of active regions being defined by a device isolation film, and the word line trench extending longitudinally in a first horizontal direction across the plurality of active regions;
a gate dielectric film in contact with the plurality of active regions and the device isolation film inside the word line trench;
a word line in a lower portion of the word line trench on the gate dielectric film, the word line extending longitudinally in the first horizontal direction;
an insulating capping pattern in an upper portion of the word line trench on the word line, the insulating capping pattern extending longitudinally in the first horizontal direction; and
a pair of source/drain regions on respective sides of the word line in one of the plurality of active regions,
wherein the word line comprises:
a work-function control conductive plug that comprises a conductive metal nitride comprising a metal dopant, the work-function control conductive plug comprising a gate top surface in contact with the insulating capping pattern and a pair of upper sidewalls in contact with the gate dielectric film, the pair of upper sidewalls facing the pair of source/drain regions, respectively, and the work-function control conductive plug extending continuously in a second horizontal direction between the pair of upper sidewalls, wherein the second horizontal direction is perpendicular to the first horizontal direction; and
a first conductive plug comprising an undoped conductive metal nitride, the first conductive plug comprising a first top surface in contact with a bottom surface of the work-function control conductive plug and a pair of first sidewalls in contact with the gate dielectric film, and the first conductive plug extending continuously in the second horizontal direction between the pair of first sidewalls.

15. The integrated circuit device of claim 14, wherein a work function of the work-function control conductive plug is less than a work function of the first conductive plug.
